# EUROPEAN PATENT APPLICATION

(11) **EP 1 906 240 A2**
(43) Date of publication of application: **02.04.2008**
(21) Application number: 07018265.4
(22) Date of filing: 18.09.2007
(51) Int. Cl.: G03F 7/004, G03F 7/039

(54) **Resist composition and pattern forming method using the same**

(30) Priority: 29.09.2006 JP 2006268604
(71) Applicant: FUJIFILM Corporation, Minato-ku Tokyo (JP)
(72) Inventor: Tsuchihashi, Toru, Haibara-gun Shizuoka (JP); Nishiyama, Fumiyuki, Haibara-gun Shizuoka (JP); Makino, Masaomi, Haibara-gun Shizuoka (JP); Mizutani, Kazuyoshi, Haibara-gun Shizuoka (JP)
(74) Representative: HOFFMANN EITLE

(57) **Abstract**

A resist composition comprises: (A) a resin containing a repeating unit represented by formula (I); and (B) at least one compound represented by formula (II) or (II'): 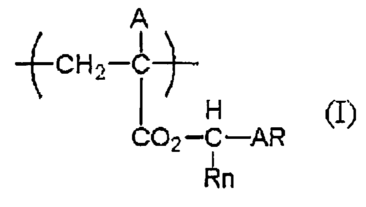 wherein AR represents a substituted or unsubstituted benzene ring or a substituted or unsubstituted naphthalene ring; Rn represents a substituted or unsubstituted alkyl group, a substituted or unsubstituted cycloalkyl group or a substituted or unsubstituted aryl group; and A represents a hydrogen atom, a substituted or unsubstituted alkyl group, a substituted or unsubstituted cycloalkyl group, a halogen atom, a cyano group or a substituted or unsubstituted alkyloxycarbonyl group; 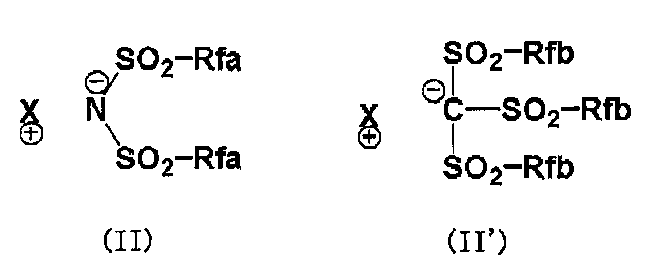 wherein Rfa and Rfb each independently represents a monovalent organic group having a fluorine atom, and two Rfa's or three Rtb's may be the same or different and may combine with each other to form a ring; and X⁺ represents a sulfonium cation or an iodonium cation, and a pattern forming method uses the same.

## Description

### Background of the Invention

### 1. Field of the Invention

The present invention relates to a resist composition suitable for use in the ultramicrolithography process such as production of VLSI or a high-capacity microchip or in other photofabrication processes. More specifically, the present invention relates to a resist capable of forming a high-resolution pattern by using KrF excimer laser light, electron beam, EUV light or the like, that is, a positive resist composition suitably usable for fine processing of a semiconductor device, where KrF excimer laser light, electron beam or EUV light is used, and a pattern forming method using the composition.

### 2. Description of the Related Art

In the process of producing a semiconductor device such as IC and LSI, fine processing by lithography using a photoresist composition has been conventionally performed. Recently, the integration degree of an integrated circuit is becoming higher and formation of an ultrafine pattern in the sub-micron or quarter-micron region is required. To cope with this requirement, the exposure wavelength also tends to become shorter, for example, from g line to i line or further to KrF excimer laser light. At present, other than the excimer laser light, development of lithography using electron beam, X ray or EUV light is proceeding.

The lithography using electron beam or EUV light is positioned as a next-generation or next-next-generation pattern formation technique and a high-sensitivity and high-resolution positive resist is being demanded. Particularly, in order to shorten the wafer processing time, the elevation of sensitivity is very important, but in the positive resist for electron beam or EUV, when higher sensitivity is sought for, not only reduction in the resolving power but also worsening of the defocus latitude depended on line pitch are incurred and development of a resist satisfying these properties at the same time is strongly demanded. The defocus latitude depended on line pitch as used herein means a difference in the pattern dimension between a high density portion and a low density portion of a resist pattern and when this difference is large, the process margin is disadvantageously narrowed at the actual pattern formation. How to reduce this difference is one of important problems to be solved in the resist technology development. The high sensitivity is in a trade-off relationship with high resolution, good pattern profile and good defocus latitude depended on line pitch and it is very important how to satisfy these properties at the same time.

Furthermore, also in the lithography using KrF excimer laser light, how to satisfy all of high sensitivity, high resolution, good pattern profile and good defocus latitude depended on line pitch is an important problem, and this problem needs to be solved.

As regards the resist suitable for such a lithography process using KrF excimer laser light, electron beam or EUV light, a chemical amplification-type resist utilizing an acid catalytic reaction is mainly used from the standpoint of elevating the sensitivity and in the case of a positive resist, a chemical amplification-type resist composition mainly comprising an acid generator and a phenolic polymer which is insoluble or sparingly soluble in an alkali developer but becomes soluble in an alkali developer under the action of an acid (hereinafter simply referred to as a "phenolic acid-decomposable resin"), is being effectively used.

With respect to such a positive resist, there are known some resist compositions using a phenolic acid-decomposable resin obtained by copolymerizing an acid-decomposable acrylate monomer having an alicyclic group as the acid-decomposable group. Examples thereof include the positive resist compositions disclosed in U.S. Patent 5,561,194, JP-A-7-234511 (the term "JP-A" as used herein means an "unexamined published Japanese patent application"), JP-A-2001-166474, JP-T-11-501909 (the term (the term "JP-T" as used herein means a "published Japanese translation of a PCT patent application") and JP-A-2002-268223.

However, by any combination of these techniques, it is impossible at present in the ultrafine region to satisfy all of good pattern profile, good performance against LWR (line width roughness) and good defocus latitude depended on line pitch.

### Summary of the Invention

An object of the present invention is to solve the problems in the technology for enhancing the performance at the fine processing of a semiconductor device using actinic rays or radiation, particularly, KrF excimer laser light, electron beam or EUV light, and provide a resist composition with high sensitivity and high resolution, which can satisfy all of good pattern profile, good LWR performance and good defocus latitude depended on line pitch and also bring about good dissolution contrast, and a pattern forming method using the composition.

The present inventors have made intensive studies, as a result, surprisingly, the object of the present invention can be attained by a resist composition comprising specific phenolic acid-decomposable resins differing in the structure and an acid generator capable of generating an acid having a specific structure, and a pattern forming method using the composition.

That is, the present invention is attained by the following constructions.
(1) A resist composition, which comprises:
   (A) a resin containing a repeating unit represented by formula (I); and
   (B) at least one compound represented by formula (II) or (II'): 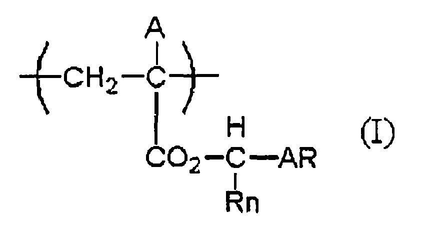 wherein AR represents a substituted or unsubstituted benzene ring or a substituted or unsubstituted naphthalene ring;
      Rn represents a substituted or unsubstituted alkyl group, a substituted or unsubstituted cycloalkyl group or a substituted or unsubstituted aryl group; and
      A represents a hydrogen atom, a substituted or unsubstituted alkyl group, a substituted or unsubstituted cycloalkyl group, a halogen atom, a cyano group or a substituted or unsubstituted alkyloxycarbonyl group: 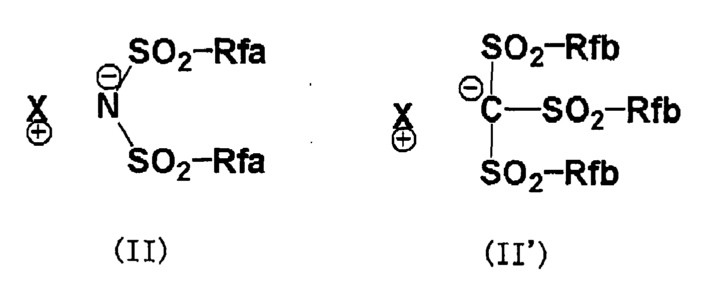 wherein Rfa and Rfb each independently represents a monovalent organic group having a fluorine atom, and two Rfa's or three Rfb's may be the same or different and may combine with each other to form a ring; and
      X⁺ represents a sulfonium cation or an iodonium cation.
(2) The resist composition as described in (1) above,
   wherein (A) the resin containing a repeating unit represented by formula (I) further contains a repeating unit represented by formula (A1); 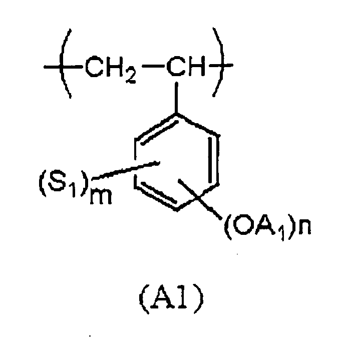 wherein n represents an integer of 0 to 3;
   m represents an integer of 0 to 3, provided that m+n≤5;
   A₁ represents a hydrogen atom or a group containing a group capable of decomposing under an action of an acid; and
   S₁ represents a substituent, and when a plurality of S₁'s are present, the plurality of S₁'s may be the same or different.
(3) The resist composition as described in (2) above,
   wherein in the repeating unit represented by formula (A1), the group containing a group capable of decomposing under an action of an acid represented by A₁ is an acetal group or a ketal group.
(4) The resist composition as described in any of (1) to (3) above,
   wherein Rfa and Rfb each independently represents a fluorine-substituted alkyl group or a fluorine-substituted aryl group, and two Rfa's or three Rib's may be the same or different and may combine with each other to form a ring.
(5) The resist composition as described in any of (1) to (4) above,
   wherein the sulfonium cation or the iodonium cation represented by X⁺ in formulae (II) and (II') has a structure represented by formula (B1) or (B2): 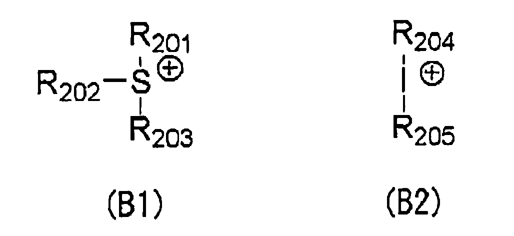 wherein in formula (B1), R₂₀₁, R₂₀₂ and R₂₀₃ each independently represents an organic group; and
   in formula (B2), R₂₀₄ and R₂₀₅ each independently represents a substituted or unsubstituted aryl group, a substituted or unsubstituted alkyl group or a substituted or unsubstituted cycloalkyl group.
(6) The resist composition as described in (5) above,
   wherein X⁺ represents the sulfonium cation having the structure represented by formula (B1), and
   the structure represented by formula (B1) is an arylsulfonium structure (B1a) in which at least one of R₂₀₁ to R₂₀₃ in formula (B1) is a substituted or unsubstituted aryl group.
(7) The resist composition as described in (5) above,
   wherein X⁺ represents the sulfonium cation having the structure represented by formula (B1), and
   the structure represented by formula (B1) is a structure (B1b) in which R₂₀₁ to R₂₀₃ in formula (B1) each independently represents an organic group not containing an aromatic ring.
(8) The resist composition as described in (5) above,
   wherein X⁺ represents the sulfonium cation having the structure represented by formula (B1), and
   the structure represented by formula (B1) is an arylacylsulfonium salt structure represented by formula (B1c): 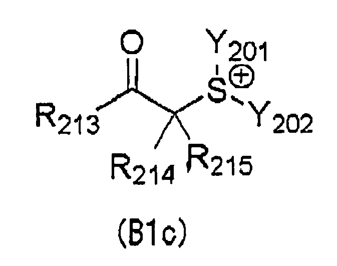 wherein R₂₁₃ represents a substituted or unsubstituted aryl group;
   R₂₁₄ and R₂₁₅ each independently represents a hydrogen atom, a substituted or unsubstituted alkyl group or a substituted or unsubstituted cycloalkyl group;
   Y₂₀₁ and Y₂₀₂ each independently represents a substituted or unsubstituted alkyl group, a substituted or unsubstituted cycloalkyl group, a substituted or unsubstituted aryl group or a substituted or unsubstituted vinyl group, provided that R₂₁₃ and R₂₁₄ may combine with each other to form a ring structure, R₂₁₄ and R₂₁₅ may combine with each other to form a ring structure, and Y₂₀₁ and Y₂₀₂ may combine with each other to form a ring structure, and the ring structure formed may contain an oxygen atom, a sulfur atom, an ester bond or an amide bond.
(9) A pattern forming method, which comprises:
   forming a resist film from the resist composition as described in any of (1) to (8) above; and
   exposing and developing the resist film.

### Detailed Description of the Invention

The compounds for use in the present invention are described in detail below.

Incidentally, in the present invention, when a group (atomic group) is denoted without specifying whether substituted or unsubstituted, the group includes both a group having no substituent and a group having a substituent. For example, an "alkyl group" includes not only an alkyl group having no substituent (unsubstituted alkyl group) but also an alkyl group having a substituent (substituted alkyl group).

The resist composition of the present invention comprises (A) a resin containing a repeating unit represented by formula (I), and (B) a compound represented by the following formula (II) or (II').

### [1] Resin containing a repeating unit represented by formula (I)

The resist composition of the present invention comprises (A) a resin containing a repeating unit represented by formula (I).

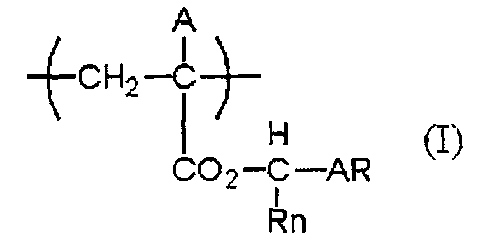

In formula (I), AR represents a benzene ring or a naphthalene ring.

Rn represents an alkyl group, a cycloalkyl group or an aryl group,

A represents a hydrogen atom, an alkyl group, a cycloalkyl group, a halogen atom, a cyano group or an alkyloxycarbonyl group.

AR represents a benzene ring or a naphthalene ring and these rings each may have one or more substituents. Examples of the substituent include a liner or branched alkyl group preferably having a carbon number of 1 to 20, such as methyl group, ethyl group, propyl group, isopropyl group, n-butyl group, isobutyl group, tert-butyl group, pentyl group, cyclopentyl group, hexyl group, cyclohexyl group, octyl group and dodecyl group, an alkoxy group, a hydroxyl group, a halogen atom, a nitro group, an acyl group, an acyloxy group, an acylamino group, a sulfonylamino group, an alkylthio group, an arylthio group, an aralkylthio group, a thiophenecarbonyloxy group, a thiophenemethylcarbonyloxy group and a heterocyclic residue such as pyrrolidone residue. Among these, a linear or branched alkyl group having a carbon number of 1 to 5 is preferred in view of resolving power.

The alkyl group or cycloalkyl group of Rn is preferably an alkyl group or cycloalkyl group having a carbon number of 20 or less, and examples thereof include a methyl group, an ethyl group, a propyl group, an isopropyl group, an n-butyl group, an isobutyl group, a tert-butyl group, a pentyl group, a cyclopentyl group, a hexyl group, a cyclohexyl group, an octyl group and a dodecyl group. These groups each may have a substituent, and preferred examples of the substituent which these groups each may have include an alkoxy group, a hydroxyl group, a halogen atom, a nitro group, an acyl group, an acyloxy group, an acylamino group, a sulfonylamino group, an alkylthio group, an arylthio group, an aralkylthio group, a thiophenecarbonyloxy group, a thiophenemethylcarbonyloxy group and a heterocyclic residue such as pyrrolidone residue. A substituent having a carbon number of 8 or less is preferred. Among these, an alkoxy group, a hydroxyl group, a halogen atom, a nitro group, an acyl group, an acyloxy group, an acylamino group and a sulfonylamino group are more preferred.

The aryl group of Rn is preferably an aryl group having a carbon number of 6 to 14, and examples thereof include a phenyl group, a xylyl group, a toluyl group, a cumenyl group, a naphthyl group and an anthracenyl group.

The alkyl group and cycloalkyl group in A are preferably an alkyl group and a cycloalkyl group each having a carbon number of 20 or less, and examples thereof include a methyl group, an ethyl group, a propyl group, an isopropyl group, an n-butyl group, an isobutyl group, a tert-butyl group, a pentyl group, a cyclopentyl group, a hexyl group, a cyclohexyl group, an octyl group and a dodecyl group. These groups each may have a substituent, and preferred examples of the substituent which these groups may have include an alkoxy group, a hydroxyl group, a halogen atom, a nitro group, an acyl group, an acyloxy group, an acylamino group, a sulfonylamino group, an alkylthio group, an arylthio group, an aralkylthio group, a thiophenecarbonyloxy group, a thiophenemethylcarbonyloxy group and a heterocyclic residue such as pyrrolidone residue. A substituent having a carbon number of 8 or less is preferred. Among those substituents, a CF₃ group, an alkyloxycarbonylmethyl group, an alkylcarbonyloxymethyl group, a hydroxymethyl group and an alkoxymethyl group are more preferred.

The halogen atom in A includes a fluorine atom, a chlorine atom, a bromine atom and an iodine atom, with a fluorine atom being preferred.

Examples of the alkyl contained in the alkyloxycarbonyl group of A are the same as those of the alkyl group in A above.

Specific examples of the repeating unit represented by formula (I) are set forth below, but the present invention is not limited thereto.

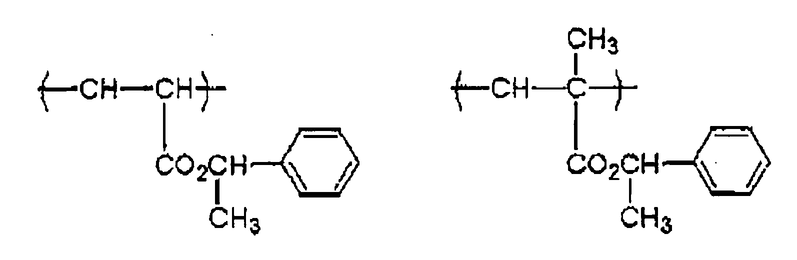

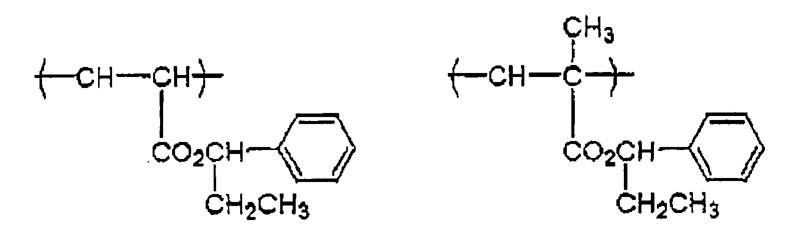

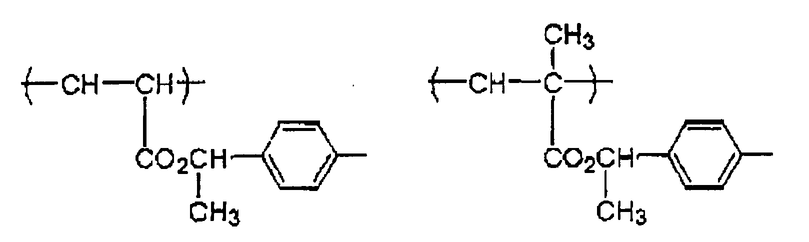

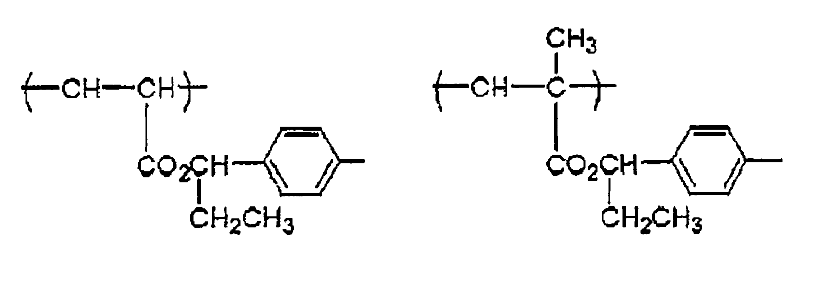

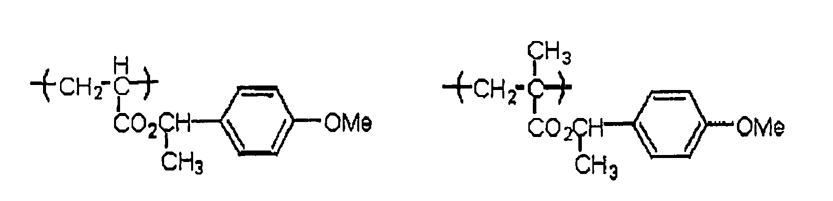

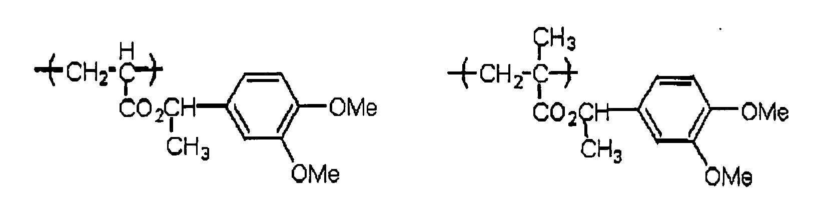

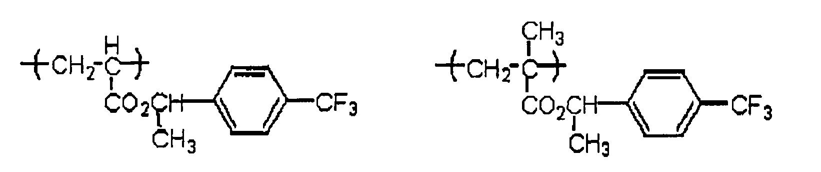

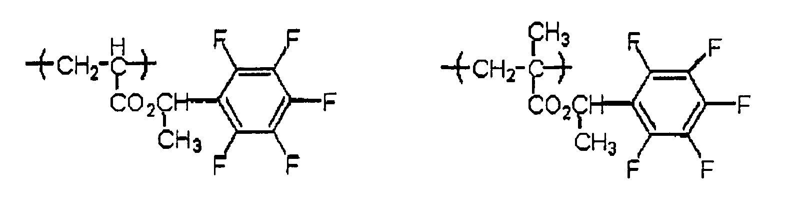

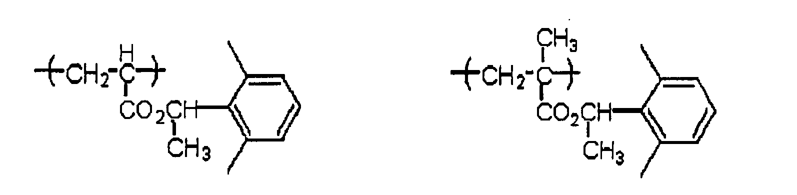

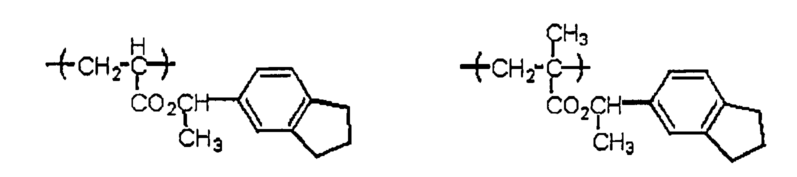

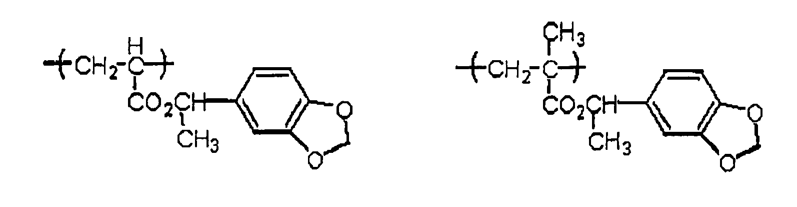

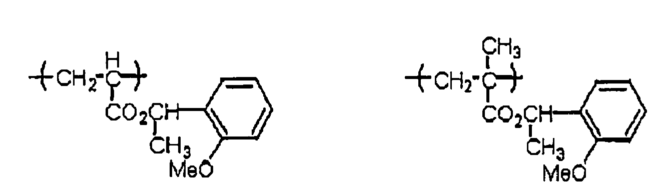

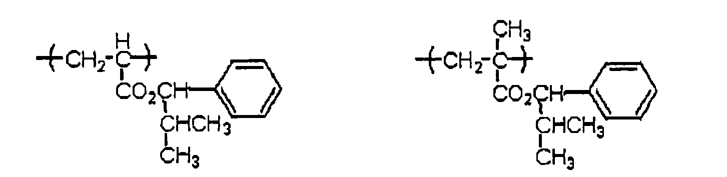

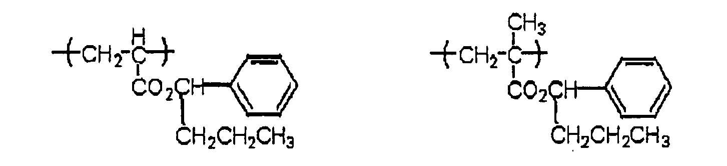

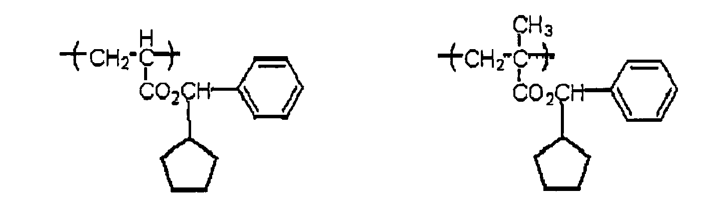

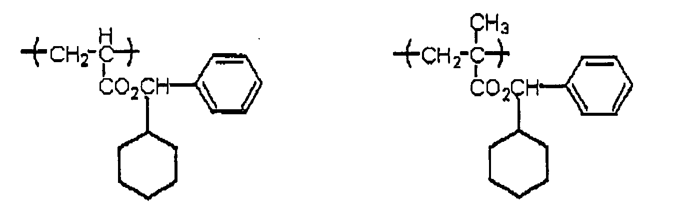

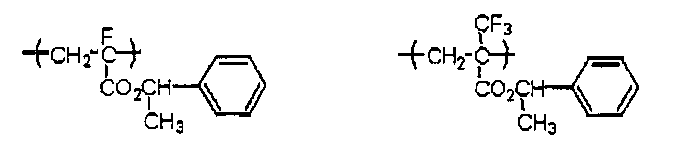

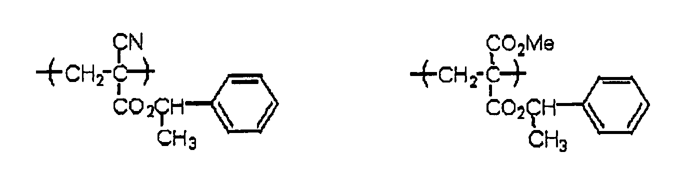

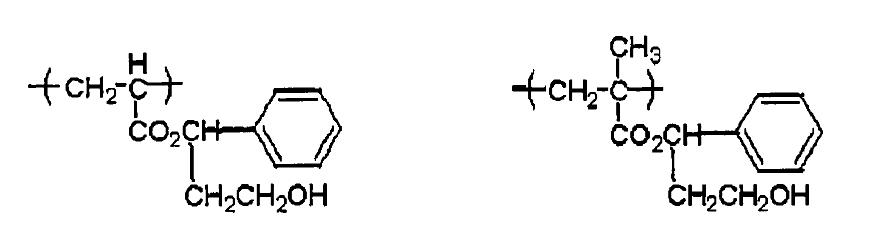

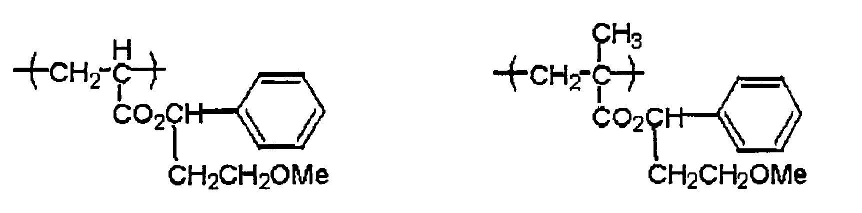

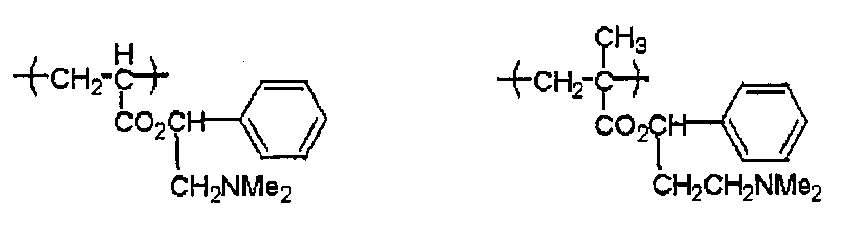

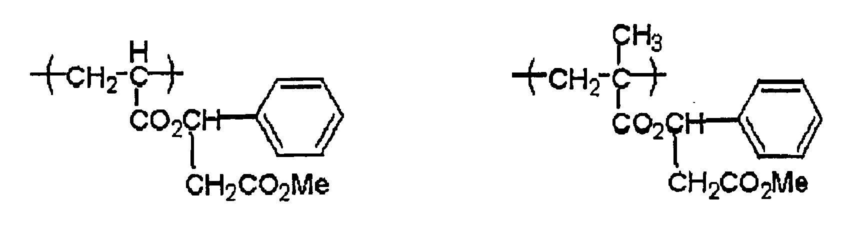

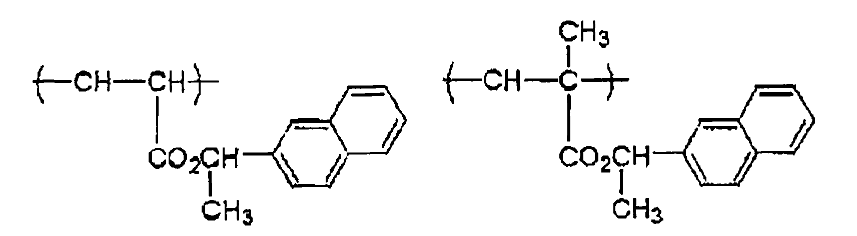

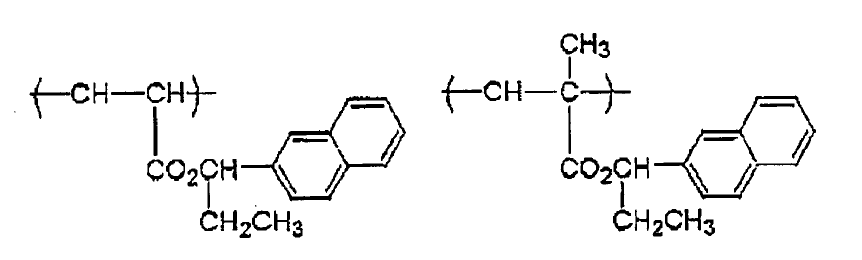

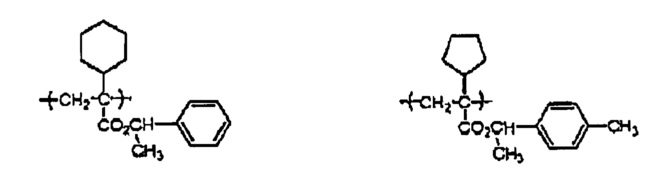

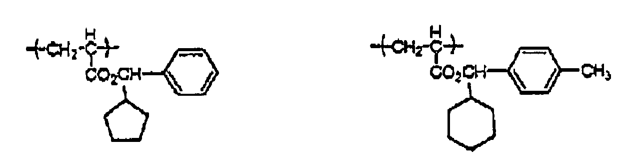

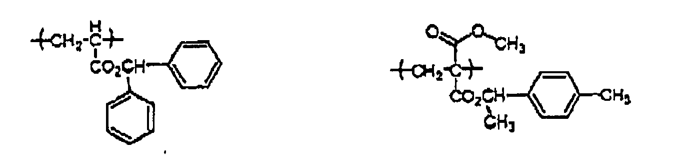

The (A) resin containing a repeating unit represented by formula (I) preferably further contains a repeating unit represented by formula (A1).

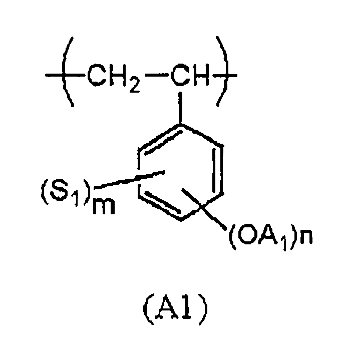

In formula (A1), n represents an integer of 0 to 3, and m represents an integer of 0 to 3, provided that m+n≤5.

A₁ represents a hydrogen atom or a group containing a group capable of decomposing under the action of an acid.

Specific examples thereof include a tertiary alkyl group such as tert-butyl group and tert-amyl group, a tert-butoxycarbonyl group, a tert-butoxycarbonylmethyl group, and an acetal group or a ketal group represented by -C(L₁)(L₂)-O-Z.

L₁ and L₂, which may be the same or different, each represents an atom or group selected from a hydrogen atom, an alkyl group, a cycloalkyl group and an aralkyl group.

Z represents an alkyl group, a cycloalkyl group or an aralkyl group.

Z and L₁ may combine with each other to form a 5- or 6-membered ring.

S₁ represents an arbitrary substituent and when a plurality of S₁'s are present, these may be the same or different. Examples thereof include an alkyl group, an alkoxy group, an acyl group, an acyloxy group, an aryl group, an aryloxy group, an aralkyl group, an aralkyloxy group, a hydroxy group, a halogen atom, a cyano group, a nitro group, a sulfonylamino group, an alkylthio goup, an arylthio group and an aralkylthio group.

For example, the alkyl group or cycloalkyl group is preferably an alkyl group or cycloalkyl group having a carbon number of 20 or less, and examples thereof include a methyl group, an ethyl group, a propyl group, an isopropyl group, an n-butyl group, an isobutyl group, a tert-butyl group, a pentyl group, a cyclopentyl group, a hexyl group, a cyclohexyl group, an octyl group and a dodecyl group, and these groups each may further have a substituent.

Preferred examples of the substituent which these groups each may further have include an alkyl group, an alkoxy group, a hydroxyl group, a halogen atom, a nitro group, an acyl group, an acyloxy group, an acylamino group, a sulfonylamino group, an alkylthio group, an arylthio group, an aralkylthio group, a thiophenecarbonyloxy group, a thiophenemethylcarbonyloxy group and a heterocyclic residue such as pyrrolidone residue. A substituent having a carbon number of 12 or less is preferred.

Examples of the alkyl group having a substituent include a cyclohexylethyl group, an alkylcarbonyloxymethyl group, an alkylcarbonyloxyethyl group, a cycloalkylcarbonyloxymethyl group, a cycloalkylcarbonyloxyethyl group, an arylcarbonyloxyethyl group, an aralkylcarbonyloxyethyl group, an alkyloxymethyl group, a cycloalkyloxymethyl group, an aryloxymethyl group, an aralkyloxymethyl group, an alkyloxyethyl group, a cycloalkyloxyethyl group, an aryloxyethyl group, an aralkyloxyethyl group, an alkylthiomethyl group, a cycloalkylthiomethyl group, an arylthiomethyl group, an aralkylthiomethyl group, an alkylthioethyl group, a cycloalkylthioethyl group, an arylthioethyl group and an aralkylthioethyl group.

The alkyl group or cycloalkyl group in these groups is not particularly limited and may further have the above-described substituent such as alkyl group, cycloalkyl group and alkoxy group.

Examples of the alkylcarbonyloxyethyl group and cycloalkylcarbonyloxyethyl group include a cyclohexylcarbonyloxyethyl group, a tert-butylcyclohexylcarbonyloxyethyl group and an n-butylcyclohexylcarbonyloxyethyl group.

The aryl group is also not particularly limited but is preferably an aryl group having a carbon number of 6 to 14, and examples thereof include a phenyl group, a xylyl group, a toluyl group, a cumenyl group, a naphthyl group and an anthracenyl group. These groups each may have the above-described substituent such as alkyl group, cycloalkyl group and alkoxy group.

Examples of the aryloxyethyl group include a phenyloxyethyl group and a cyclohexylphenyloxyethyl group. These groups each may further have a substituent

The aralkyl is also not particularly limited but examples thereof include a benzyl group.

Examples of the aralkylcarbonyloxyethyl group include a benzylcarbonyloxyethyl group. This group may further have a substituent.

In the present invention, the group containing a group capable of decomposing under the action of an acid may be a group where as a result of desorption of A₁, a hydroxyl group is produced in the repeating unit represented by formula (A1), that is, an acid-decomposable group itself, or may be a group containing an acid-decomposable group, that is, a group where as a result of decomposition under the action of an acid, an alkali-soluble group such as hydroxyl group or carboxyl group is produced in the residue bonded to the repeating unit.

The monomer corresponding to the repeating unit represented by formula (I) may be synthesized by esterifying a (meth)acrylic acid chloride and an alcohol compound in a solvent such as THF, acetone and methylene chloride in the presence of a basic catalyst such as triethylamine, pyridine and DBU. A commercially available product may also be used.

The monomer corresponding to the repeating unit represented by formula (A1) may be synthesized by acetalizing a hydroxy-substituted styrene monomer and a vinyl ether compound in a solvent such as THF and methylene chloride in the presence of an acidic catalyst such as p-toluenesulfonic acid and pyridine p-toluenesulfonate, or by effecting t-Boc protection with use of tert-butyl dicarboxylate in the presence of a basic catalyst such as triethylamine, pyridine and DBU. A commercially available product may also be used.

Specific examples of the repeating unit represented by formula (A1) are set forth below, but the present invention is not limited thereto.

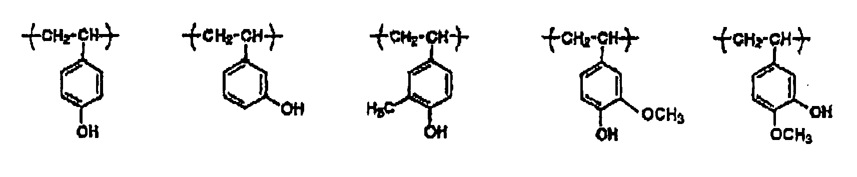

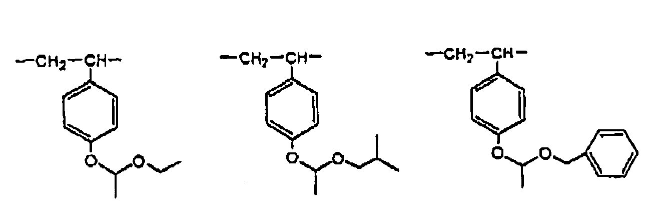

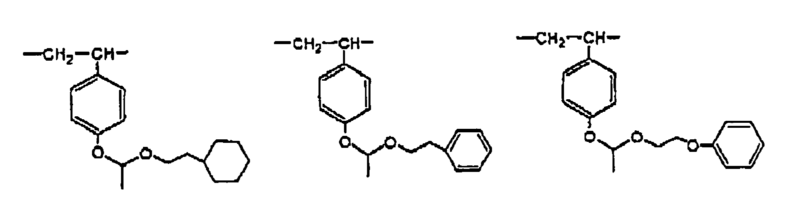

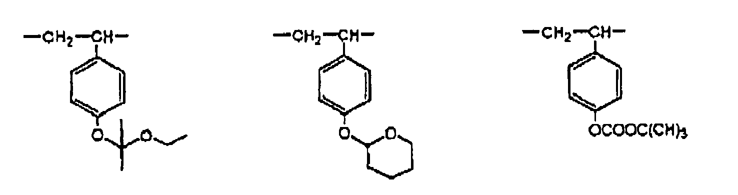

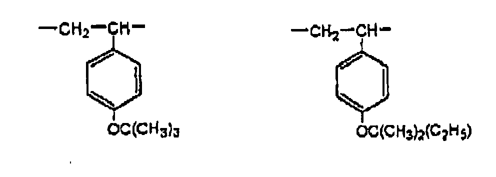

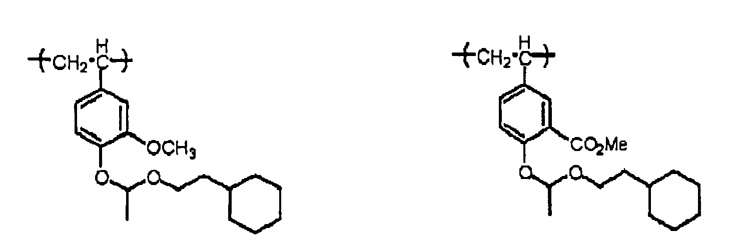

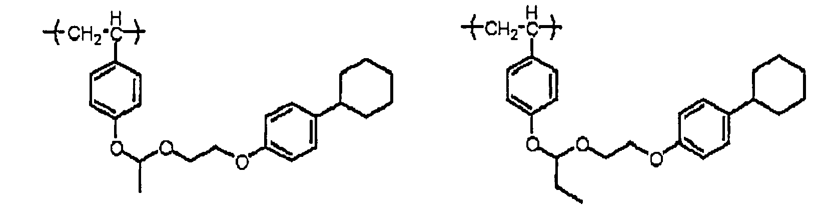

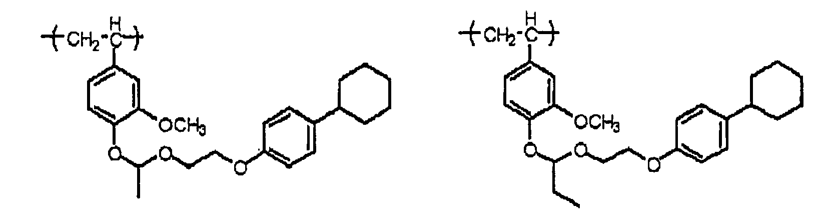

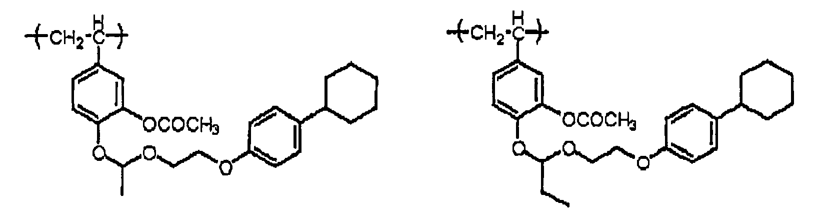

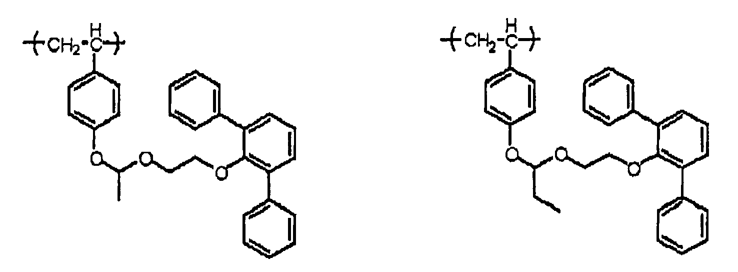

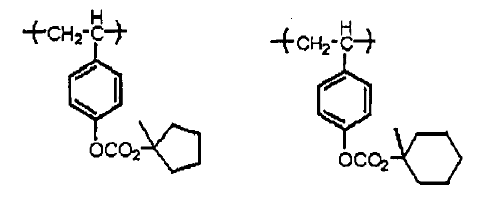

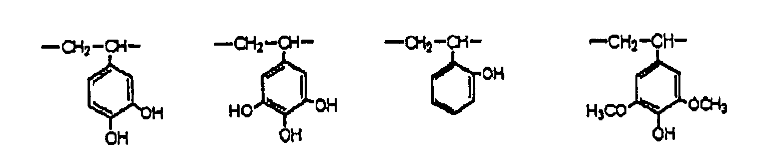

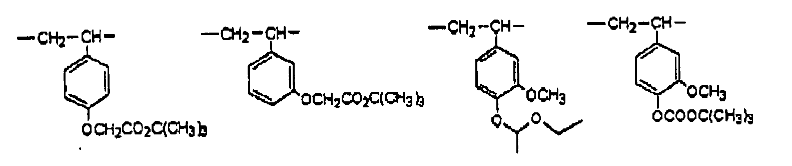

The resin (A) preferably further contains a repeating unit represented by formula (A4).

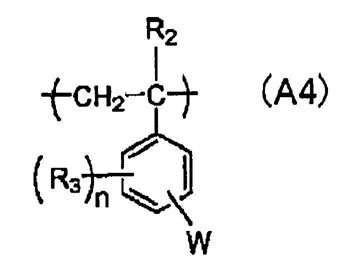

In formula (A4), R₂ represents a hydrogen atom, a methyl group, a cyano group, a halogen atom or a perfluoro group (having a carbon number of 1 to 4).

R₃ represents a hydrogen atom, an alkyl group, a halogen atom, an aryl group, an alkoxy group or an acyl group.

n represents an Integer of 0 to 4.

W represents a group incapable of decomposing under the action of an acid.

W represents a group incapable of decomposing under the action of an acid (sometimes referred to as an "acid-stable group"), and specific examples thereof include a hydrogen atom, a halogen atom, an alkyl group, a cycloalkyl group, an alkenyl group, an aryl group, an acyl group, an alkylamido group, an arylamidomethyl group and an arylamido group. The acid-stable group is preferably an acyl group or an alkylamido group, more preferably an acyl group, an alkylcarbonyloxy group, an alkyloxy group, a cycloalkyloxy group or an aryloxy group.

In the acid-stable group represented by W, the alkyl group is preferably an alkyl group having a carbon number of 1 to 4, such as methyl group, ethyl group, propyl group, n-butyl group, sec-butyl group and tert-butyl group; the cycloalkyl group is preferably a cycloalkyl group having a carbon number of 3 to 10, such as cyclopropyl group, cyclobutyl group, cyclohexyl group and adamantyl group; the alkenyl group is preferably an alkenyl group having a carbon number of 2 to 4, such as vinyl group, propenyl group, allyl goup and butenyl group; the alkenyl group is preferably an alkenyl group having a carbon number of 2 to 4, such as vinyl group, propenyl group, allyl group and butenyl group; and the aryl group is preferably an aryl group having a carbon number of 6 to 14, such as phenyl group, xylyl group, toluyl group, cumenyl group, naphthyl group and anthracenyl group. W may be present at any position on the benzene ring but is preferably present at the meta-position or para-position, more preferably at the para-position, of the styrene skeleton.

Specific examples of the repeating unit represented by formula (A4) are set forth below, but the present invention is not limited thereto.

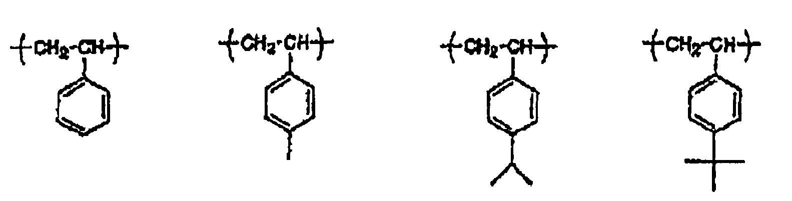

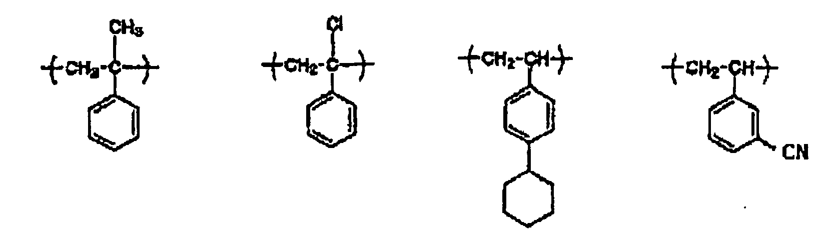

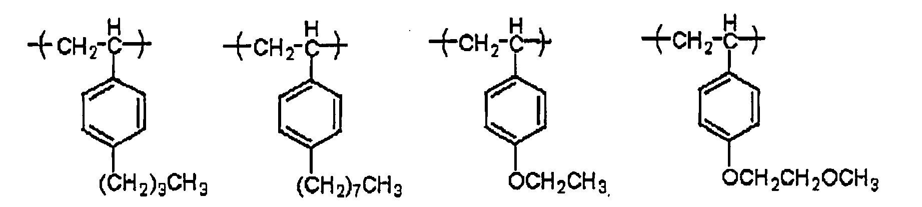

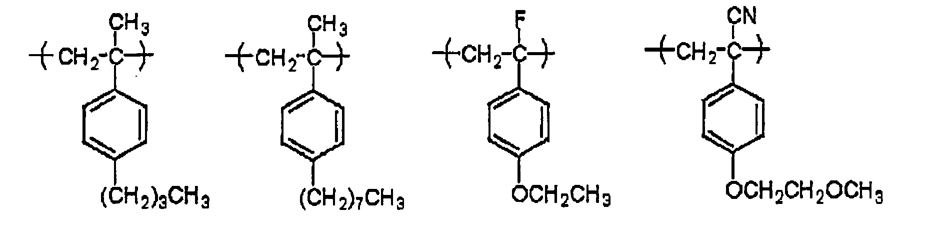

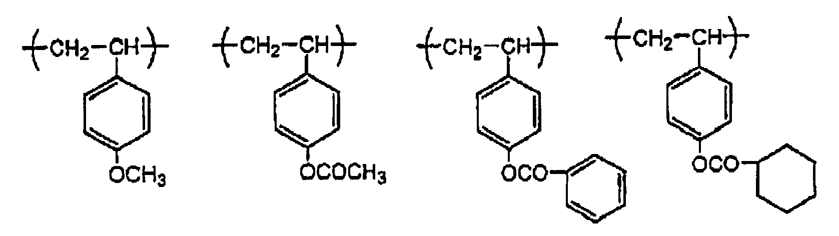

The resin (A) preferably further contains a repeating unit comprising a (meth)acrylic acid derivative incapable of decomposing under the action of an acid. Specific examples thereof are set forth below, but the present invention is not limited thereto.

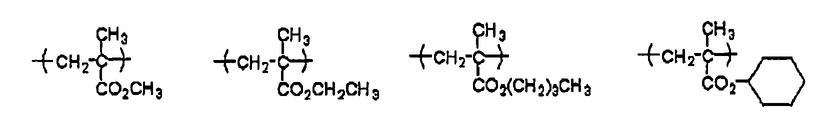

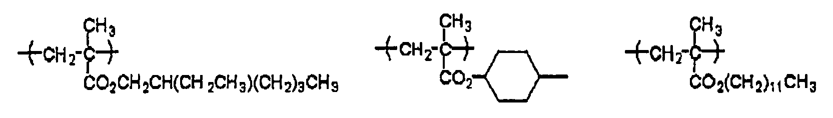

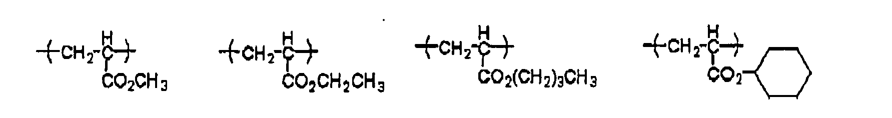

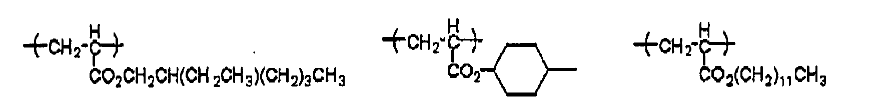

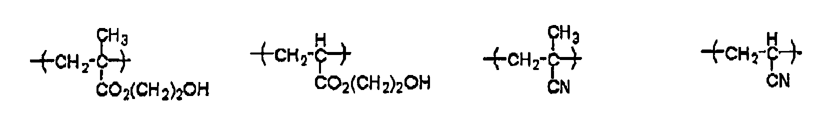

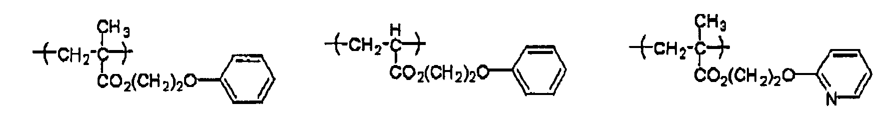

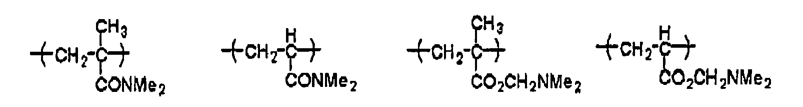

The repeating unit represented by formula (I) decomposes under the action of an acid and produces a carboxyl group and therefore, the resin (A) is a resin of which solubility in an alkali developer increases under the action of an acid (acid-decomposable resin), and preferably contains a group (acid-decomposable group) capable of decomposing under the action of an acid to produce an alkali-soluble group, in an arbitrary repeating unit.

As described above, in addition to the repeating unit represented by formula (I), other repeating units such as repeating unit represented by formula (A1) may also contain an acid-decomposable group.

Examples of the acid-decomposable group include, in addition to those described above, a group represented by -C(=O)-X₁-R₀.

In the formula above, R₀ represents, for example, a tertiary alkyl group such as tert-butyl group and tert-amyl group, an isobornyl group, a 1-alkoxyethyl group such as 1-ethoxyethyl group, 1-butoxyethyl group, 1-isobutoxyethyl group and 1-cyclohexyloxyethyl group, an alkoxymethyl group such as 1-methoxymethyl group and 1-ethoxymethyl group, a 3-oxoalkyl group, a tetrahydropyranyl group, a tetrahydrofuranyl group, a trialkylsilyl ester group, a 3-oxocyclohexyl ester group, a 2-methyl-2-adamantyl group, or a mevalonic lactone residue. X₁ represents an oxygen atom, a sulfur atom, -NH-, -NHSO₂- or -NHSO₂NH-.

The content of the acid-decomposable group-containing repeating unit in the resin (A) is preferably from 1 to 50 mol%, more preferably from 3 to 40 mol%, still more preferably from 5 to 30 mol%, based on all repeating units.

The content of the repeating unit represented by formula (I) in the resin (A) is preferably from 5 to 60 mol%, more preferably from 8 to 40 mol%, still more preferably from 10 to 30 mol%, based on all repeating units.

The content of the repeating unit represented by formula (A1) in the resin (A) is preferably from 40 to 90 mol%, more preferably from 50 to 85 mol%, still more preferably from 60 to 80 mol%, based on all repeating units.

The resin (A) may further contain a repeating unit represented by formula (A4), and this is preferred from the standpoint of, for example, enhancing the film quality or suppressing the film loss in the unexposed area. The content of the repeating unit represented by formula (A4) is preferably from 0 to 50 mol%, more preferably from 0 to 40 mol%, still more preferably from 0 to 30 mol%, based on all repeating units.

In the resin (A), other appropriate polymerizable monomers may be copolymerized to introduce an alkali-soluble group such as phenolic hydroxyl group or carboxyl group for maintaining good developability with an alkali developer, or other hydrophobic polymerizable monomers such as alkyl acrylate or alkyl methacrylate may be copolymerized for enhancing the film quality.

The weight average molecular weight (Mw) of the resin (A) is preferably from 3,000 to 30,000, more preferably from 5,000 to 20,000. The dispersity (Mw/Mn) is preferably from 1.0 to 2.0, more preferably from 1.0 to 1.8, still more preferably from 1.0 to 1.7.

The weight average molecular weight here is defined as a polystyrene-reduced value determined by gel permeation chromatography.

The resin (A) having a dispersity of 1.5 to 2.0 can be synthesized by radical polymerization using an azo-based polymerization initiator. Also, the resin (A) having a still more preferred dispersity of 1.0 to 1.7 can be synthesized by living radical polymerization.

Two or more species of the resin (A) may be used in combination.

The amount of the resin (A) added is, as the total amount, usually from 10 to 96 mass%, preferably from 15 to 96 mass%, more preferably from 20 to 95 mass%, based on the entire solid content of the resist composition. (In this specification, mass ratio is equal to weight ratio.)

Specific examples of (A) the resin containing a repeating unit represented by formula (I) are set forth below, but the present invention is not limited thereto.

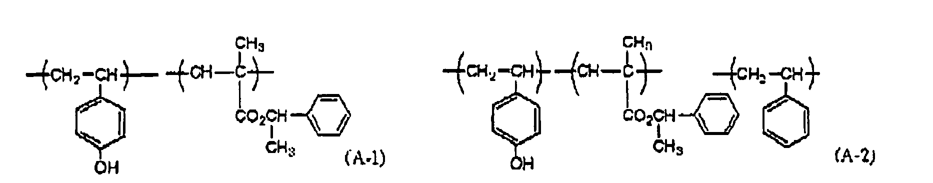

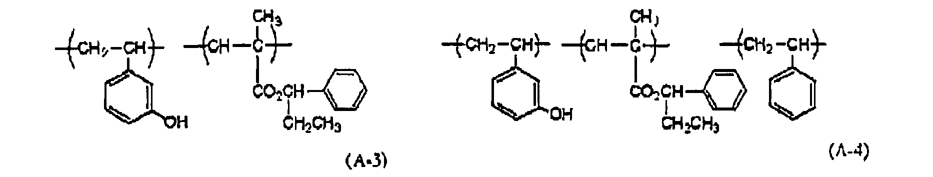

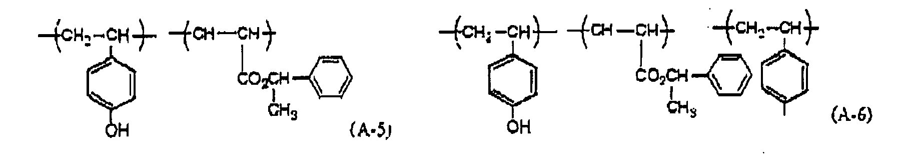

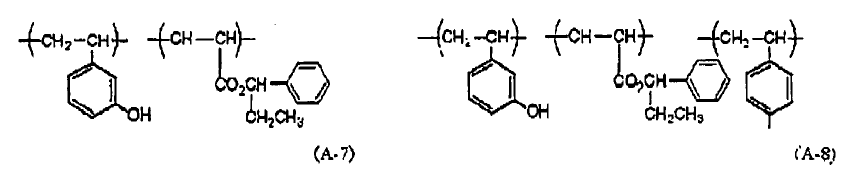

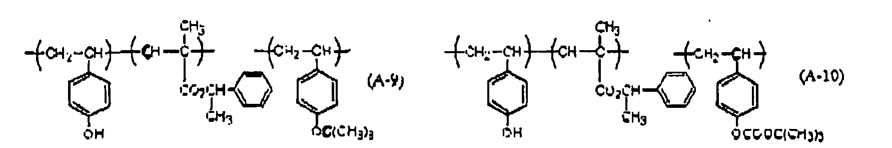

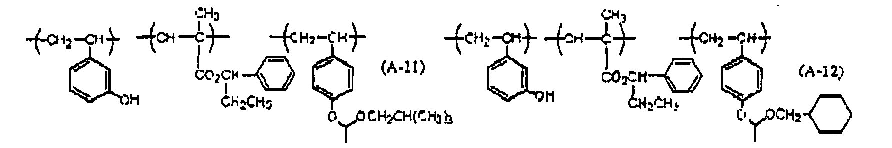

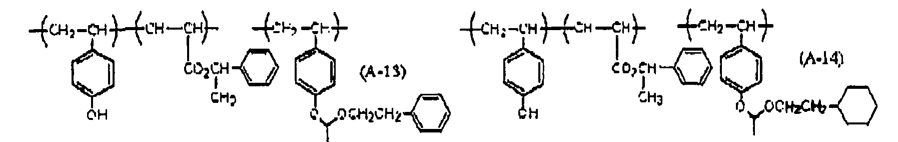

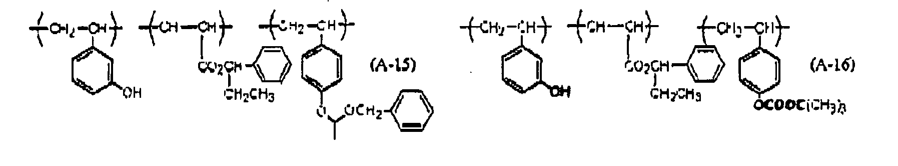

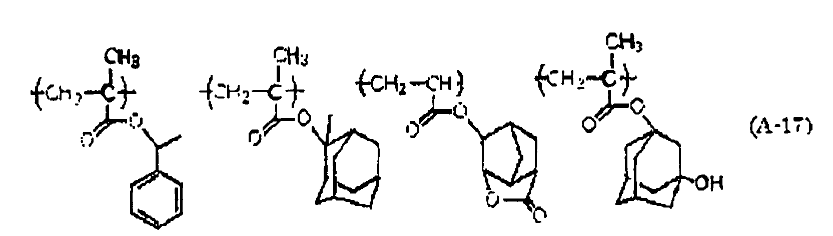

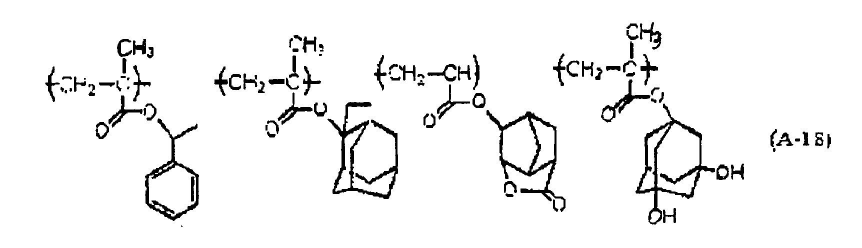

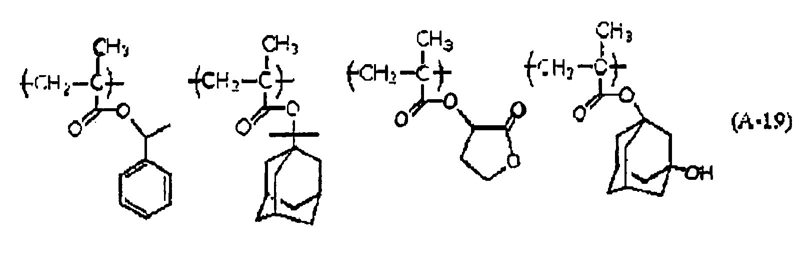

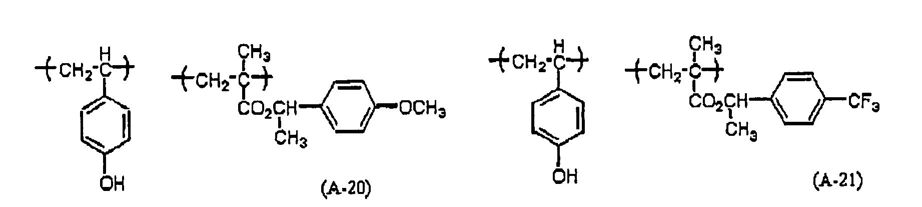

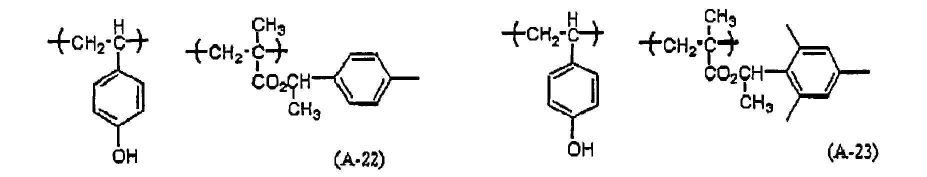

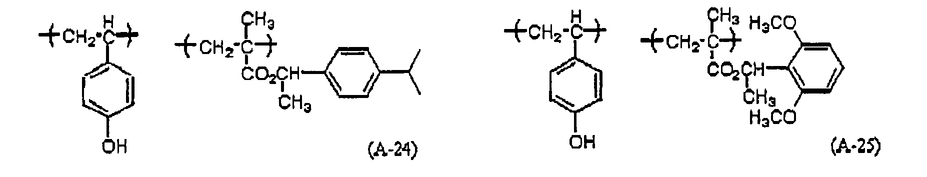

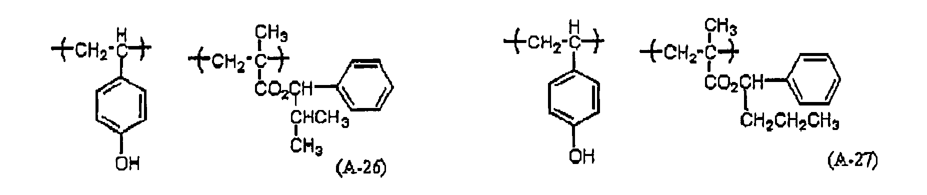

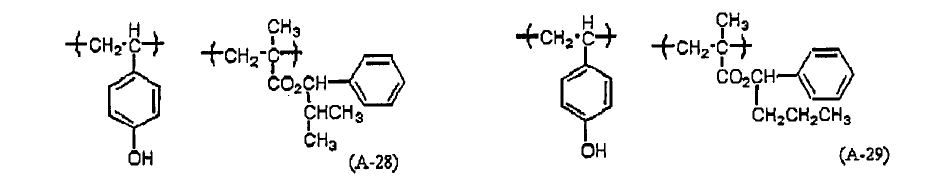

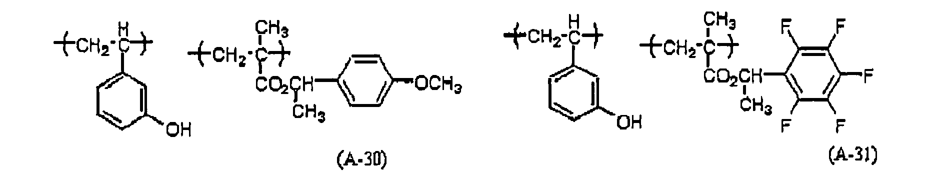

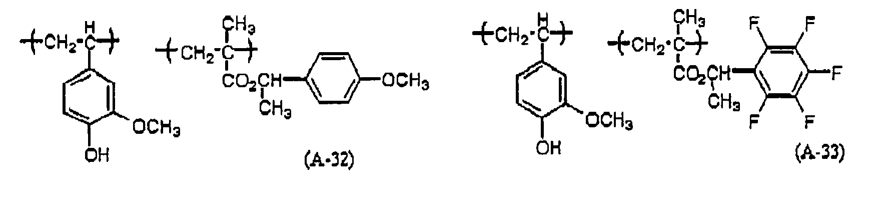

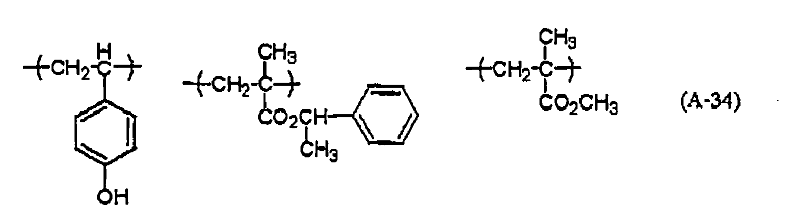

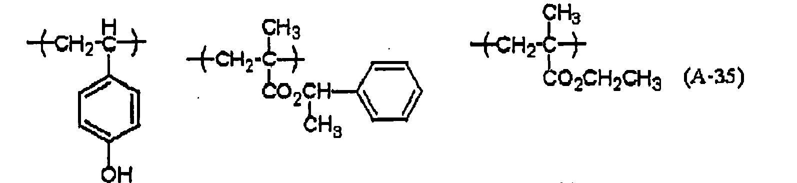

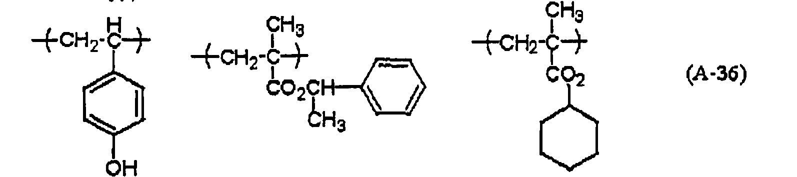

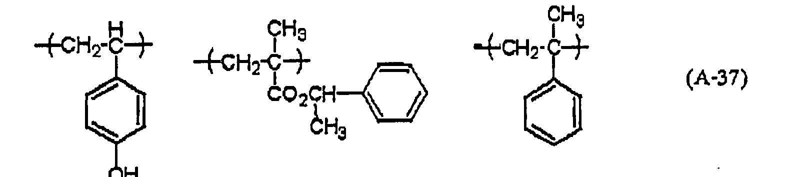

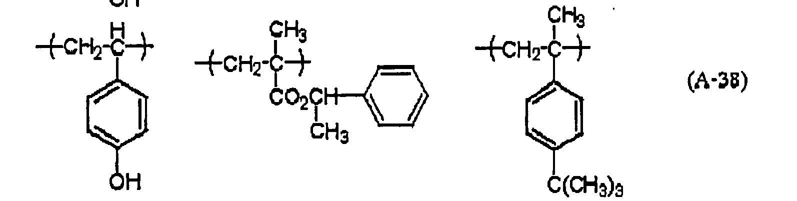

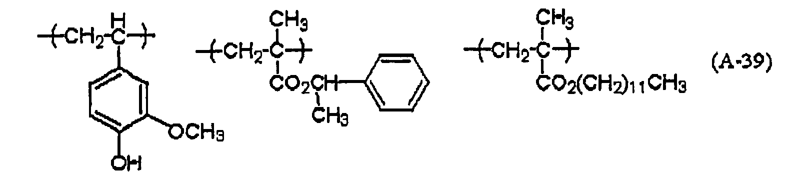

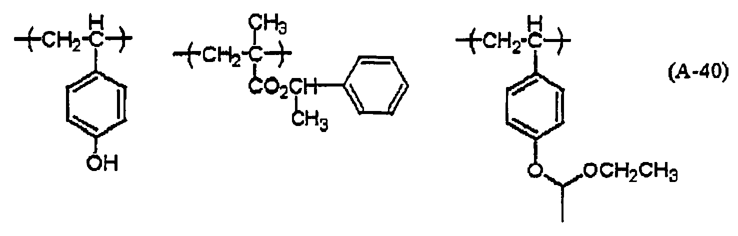

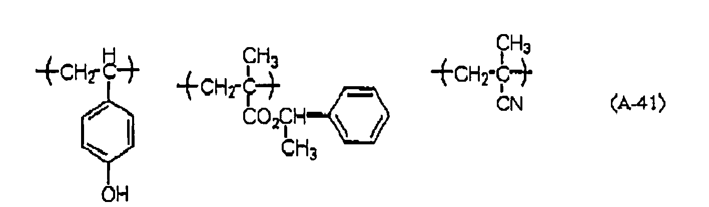

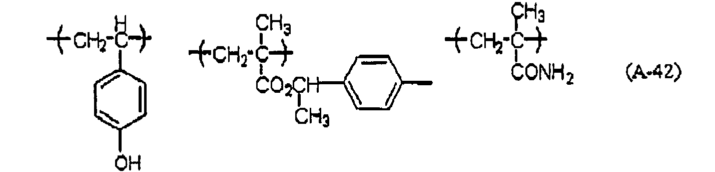

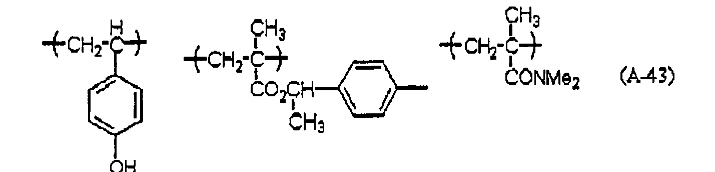

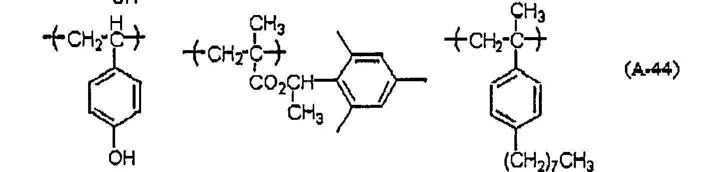

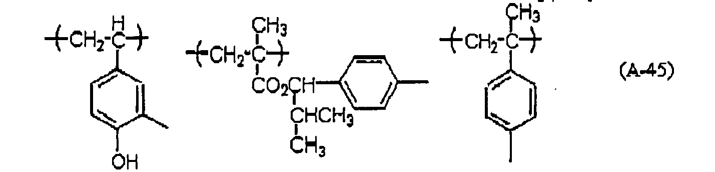

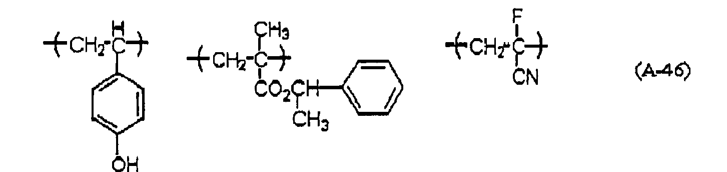

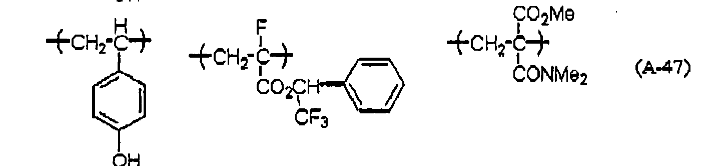

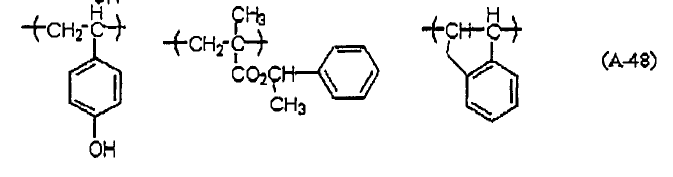

In the case of irradiating KrF excimer laser light, electron beam, X ray or high-energy beam at a wavelength of 50 nm or less (e.g., EUV), the resist composition of the present invention may contain a hydroxystyrene copolymer protected by hydroxystyrene/acid-decomposable group, or a hydroxystyrene/tertiary alkyl (meth)acrylate copolymer. The amount added of such a resin is, as the total amount, from 0 to 50 mass%, preferably from 0 to 20 mass%, based on the entire solid content of the resist composition.

Specific examples thereof are set forth below, but the present invention is not limited thereto.

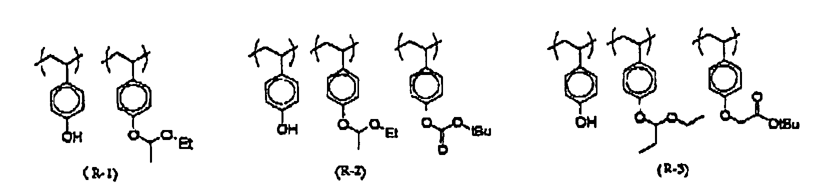

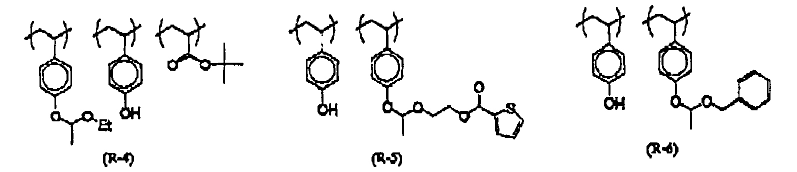

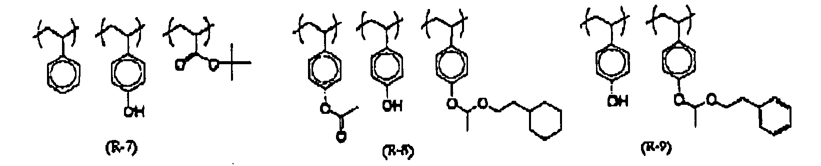

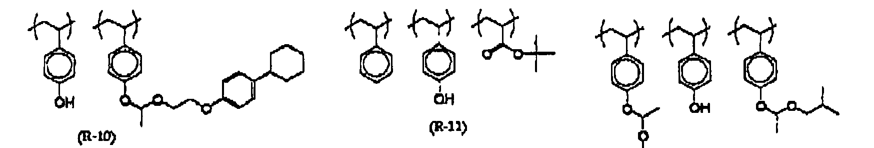

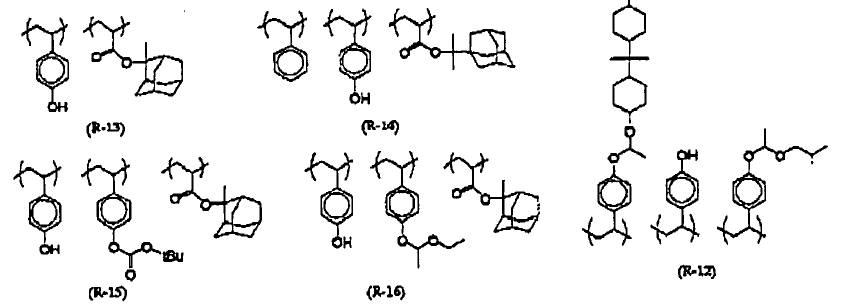

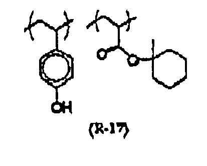

In these specific examples, "tBu" indicates a tert-butyl group.

The content of the group capable of decomposing under the action of an acid is expressed by B/(B+S) using the number (B) of acid-decomposable groups in the resin and the number (S) of alkali-soluble groups not protected by a group which desorbs by the effect of an acid. The content is preferably from 0.01 to 0.7, more preferably from 0.05 to 0.50, still more preferably from 0.05 to 0.40.

### [1] (B) Acid generator

The photosensitive composition of the present invention comprises a compound represented by the following formula (II) or (II'), which generates an acid upon irradiation with actinic rays or radiation (hereinafter sometimes referred to as a "compound (B)").

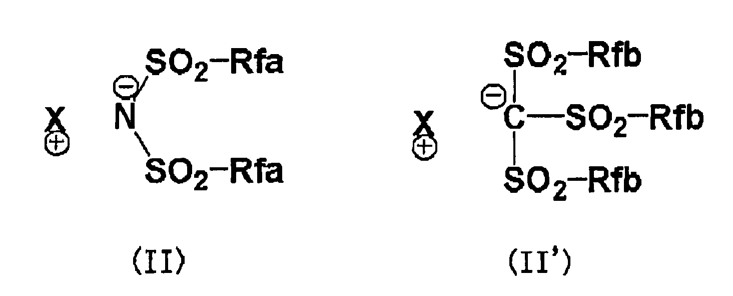

In formulae (II) and (II'), Rfa and Rfb each represents a monovalent organic group having a fluorine atom. Rfa's or Rfb's may be the same or different and may combine with each other to form a ring.

X⁺ represents a sulfonium cation or an iodonium cation.

Examples of the fluorine atom-containing monovalent organic group of Rfa in formula (II) include a fluorine-substituted alkyl group and a fluorine-substituted aryl group.

Examples of the fluorine-substituted alkyl group include a linear or branched alkyl group having a carbon number of 1 to 20, such as methyl group, ethyl group, propyl group, isopropyl group and octyl group, with at least one hydrogen atom being substituted by a fluorine atom. An oxygen atom or a sulfur atom may be contained in such an organic group.

The fluorine-substituted alkyl group may have a substituent other than the fluorine atom, and preferred examples of the other substituent include an aryl group, an alkoxy group and an iodine atom.

Also, the fluorine-substituted alkyl group preferably has the fluorine atom on the carbon atom bonded to the -SO₂NSO₂- moiety. The fluorine-substituted alkyl group is more preferably a linear or branched perfluoroalkyl goup having a carbon number of 1 to 8, such as perfluoromethyl group, perfluoroethyl group, perfluoropropyl group, perluoroisopropyl group and perfluorooctyl group. By virtue of such a fluorine-substituted alkyl group, the solubility in a solvent is enhanced.

The fluorine-substituted aryl group of Rfa includes an aryl group which is entirely or partially substituted by a fluorine atom and which may be substituted by other substituents. The fluorine-substituted aryl group is preferably a fluorine-substituted phenyl or naphthyl group, and most preferably a perfluorophenyl group.

Examples of the fluorine atom-containing monovalent organic group of Rfb in formula (II') include a fluorine-containing alkyl group and a fluorine-substituted aryl group.

Examples of the fluorine-substituted alkyl group include a linear or branched alkyl group having a carbon number of 1 to 8, such as methyl group, ethyl group, propyl group, isopropyl group and octyl group, with at least one hydrogen atom being substituted by a fluorine atom. An oxygen atom or a sulfur atom may be contained in such an organic group.

The fluorine-substituted alkyl group may have a substituent other than the fluorine atom, and preferred examples of the other substituent include an alkoxy group and an iodine atom.

Also, the fluorine-substituted alkyl group preferably has the fluorine atom on the carbon atom bonded to the -SO₂CSO₂- moiety. The fluorine-substituted alkyl group is more preferably a linear or branched perfluoroalkyl group having a carbon number of 1 to 8, such as perfluoromethyl group, perfluoroethyl group, perfluoropropyl group, perluoroisopropyl group and perfluorooctyl group. By virtue of such a fluorine-substituted alkyl group, the solubility in a solvent is enhanced. Three Rfb's may be the same or different and may combine with each other to form a ring. By virtue of forming a ring, the stability is enhanced and the storage stability of the composition using it is enhanced. In the case of forming a ring, the alkylene group formed resulting from two or more Rfb's being combined preferably has a carbon number of 2 to 3, and hydrogen atoms therein all are preferably perfluoronated.

The fluorine-substituted aryl group of Rfb includes an aryl group which is entirely or partially substituted by a fluorine atom and which may be substituted by other substituents. The fluorine-substituted aryl group is preferably a fluorine-substituted phenyl or naphthyl group, and most preferably a perfluorophenyl group. Three Rfb's may be the same or different.

In formulae (II) and (II'), X⁺ represents a sulfonium cation or an iodonium cation and preferably has a structure represented by the following formula (B1) or (B2).

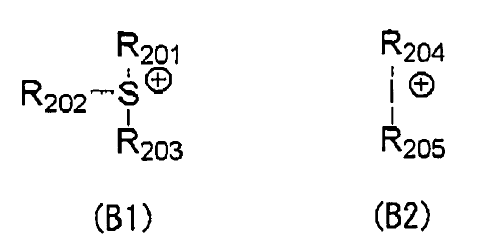

In formula (B1), R₂₀₁, R₂₀₂ and R₂₀₃ each independently represents an organic group.

In formula (B2), R₂₀₄ and R₂₀₅ each independently represents an aryl group, an alkyl group or a cycloalkyl group.

The number of carbons in the organic group as R₂₀₁, R₂₀₂ and R₂₀₃ in formula (B1) is generally from 1 to 30, preferably from 1 to 20.

Two members out of R₂₀₁ to R₂₀₃ may combine to form a ring structure, and the ring may contain an oxygen atom, a sulfur atom, an ester bond, an amide bond or a carbonyl group.

Examples of the group formed resulting from two members out of R₂₀₁ to R₂₀₃ being combined include an alkylene group (e.g., butylene, pentylene).

Specific examples of the organic group as R₂₀₁, R₂₀₂ and R₂₀₃ include corresponding groups in the structures (B1a), (B1b) and (B1c) which are described later.

The compound may be have a plurality of structures represented by formula (B1), for example, may have a structure where at least one of R₂₀₁ to R₂₀₃ in the structure represented by formula (B1) is bonded to at least one of R₂₀₁ to R₂₀₃ in another compound represented by formula (B1).

The preferred structure of (B1) includes structures (B1a), (B1b) and (B1c) described below.

The structure (B1a) is an arylsulfonium structure where at least one of R₂₀₁ to R₂₀₃ in formula (B1) is an aryl group, that is, a compound having an arylsulfonium as the cation.

In the arylsulfonium structure, R₂₀₁ to R₂₀₃ all may be an aryl group or a part of R₂₀₁ to R₂₀₃ may be an aryl group with the remaining being an alkyl group or a cycloalkyl group.

Examples of the arylsulfonium structure include a triarylsulfonium structure, a diarylalkylsulfonium structure, a diarylcycloalkylsulfonium structure, an aryldialkylsulfonium structure, an aryldicycloalkylsulfonium structure and an arylalkylcycloalkylsulfonium structure.

The aryl group in the arylsulfonium structure is preferably a phenyl group or a naphthyl group, more preferably a phenyl group. In the case where the arylsulfonium structure has two or more aryl groups, these two or more aryl groups may be the same of different.

The alkyl group which is present, if desired, in the arylsulfonium structure is preferably a linear or branched alkyl group having a carbon number of 1 to 15, and examples thereof include a methyl group, an ethyl group, a propyl group, an n-butyl group, a sec-butyl group, a tert-butyl group, a cyclopropyl group, a cyclobutyl group and a cyclohexyl group.

The cycloalkyl group which is present, if desired, in the arylsulfonium structure is preferably a cycloalkyl group having a carbon number of 3 to 15, and examples thereof include a cyclopropyl group, a cyclobutyl group and a cyclohexyl group.

The aryl group, alkyl group and cycloalkyl group of R₂₀₁ to R₂₀₃ each may have, as the substituent, an alkyl group (for example, an alkyl group having a carbon number of 1 to 15), a cycloalkyl group (for example, a cycloalkyl group having a carbon number of 3 to 15), an aryl group (for example, an aryl group having a carbon number of 6 to 14), an alkoxy group (for example, an alkoxy group having a carbon number of 1 to 15), a halogen atom, a hydroxyl group or a phenylthio group. The substituent is preferably a linear or branched alkyl group having a carbon number of 1 to 12, a cycloalkyl group having a carbon number of 3 to 12, or a linear, branched or cyclic alkoxy group having a carbon number of 1 to 12, and most preferably an alkyl group having a carbon number of 1 to 4, or an alkoxy group having a carbon number of 1 to 4. The substituent may be substituted to any one of three members R₂₀₁ to R₂₀₃ or may be substituted to all of these three members. In the case where R₂₀₁ to R₂₀₃ each is an aryl group, the substituent is preferably substituted at the p-position of the aryl group.

The structure (B1b) is described below.

The structure (B1b) is a structure where R₂₀₁ to R₂₀₃ in formula (B1) each independently represents an organic group not containing an aromatic ring. The aromatic ring as used herein includes an aromatic ring having a heteroatom.

The aromatic ring-free organic group of R₂₀₁ to R₂₀₃ has a carbon number of generally from 1 to 30, preferably from 1 to 20.

The aromatic ring-free organic group of R₂₀₁ to R₂₀₃ is preferably an alkyl group, a cycloalkyl group, an allyl group or a vinyl group, more preferably a linear, branched or cyclic oxoalkyl group which may have a double bond in the chain, still more preferably a linear, branched or cyclic 2-oxoalkyl group, yet still more preferably a linear or branched 2-oxoalkyl group.

The alkyl group of R₂₀₁ to R₂₀₃ may be either linear or branched and is preferably a linear or branched alkyl group having a carbon number of 1 to 20 (e.g., methyl, ethyl, propyl, butyl, pentyl). The alkyl group of R₂₀₁ to R₂₀₃ is more preferably a linear or branched oxoalkyl group or an alkoxycarbonylmethyl group.

The cycloalkyl group of R₂₀₁ to R₂₀₃ is preferably a cycloalkyl group having a carbon number of 3 to 10 (e.g., cyclopentyl, cyclohexyl, norbornyl). The cycloalkyl group of R₂₀₁ to R₂₀₃ is more preferably a cyclic oxoalkyl group.

The oxoalkyl group of R₂₀₁ to R₂₀₃ may be linear, branched or cyclic and is preferably a group having >C=O at the 2-position of the alkyl or cycloalkyl group above.

The alkoxy group in the alkoxycarbonylmethyl group of R₂₀₁ to R₂₀₃ is preferably an alkoxy group having a carbon number of 1 to 5 (e.g., methoxy, ethoxy, propoxy, butoxy, pentoxy).

R₂₀₁ to R₂₀₃ each may be further substituted by a halogen atom, an alkoxy group (for example, an alkoxy group having a carbon number of 1 to 5), a hydroxyl group, a cyano group or a nitro group.

The structure (B1c) is a structure represented by the following formula (B1c), and this is an arylacylsulfonium salt structure.

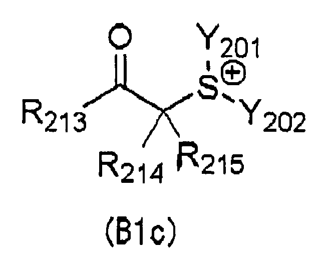

In formula (B1c), R₂₁₃ represents an aryl group and is preferably a phenyl group or a naphthyl group. The aryl group of R₂₁₃ may have a substituent. Examples of the substituent which the aryl group of R₂₁₃ may have include an alkyl group, an alkoxy group, an acyl group, a nitro group, a hydroxyl group, an alkoxycarbonyl group and a carboxy group.

R₂₁₄ and R₂₁₅ each independently represents a hydrogen atom, an alkyl group or a cycloalkyl group.

Y₂₀₁ and Y₂₀₂ each independently represents an alkyl group, a cycloalkyl group, an aryl group or a vinyl group.

R₂₁₃ and R₂₁₄ may combine with each other to form a ring structure, R₂₁₄ and R₂₁₅ may combine with each other to form a ring structure, and Y₂₀₁ and Y₂₀₂ may combine with each other to form a ring structure. The ring structure formed may contain an oxygen atom, a sulfur atom, an ester bond or an amide bond.

The alkyl group of R₂₁₄ and R₂₁₅ is preferably a linear or branched alkyl group having a carbon number of 1 to 20.

The cycloalkyl group of R₂₁₄ and R₂₁₅ is preferably a cycloalkyl group having a carbon number of 3 to 20.

The alkyl group of Y₂₀₁ and Y₂₀₂ is preferably a linear or branched alkyl group having a carbon number of 1 to 20, more preferably a 2-oxoallcyl group having >C=O at the 2-position of the alkyl group, an alkoxycarbonylalkyl group (preferably with an alkoxy group having a carbon number of 2 to 20), or a carboxyalkyl group.

The cycloalkyl group of Y₂₀₁ and Y₂₀₂ is preferably a cycloalkyl group having a carbon number of 3 to 20.

The aryl group of Y₂₀₁ and Y₂₀₂ is preferably an aryl group having a carbon number of 6 to 20.

Examples of the group formed resulting from each pair of R₂₁₃ and R₂₁₄, R₂₁₄ and R₂₁₅, or Y₂₀₁ and Y₂₀₂ being combined include a butylene group and a pentylene group.

Y₂₀₁ and Y₂₀₂ each is preferably an alkyl group having a carbon number of 4 or more, more preferably from 4 to 16, still more preferably from 4 to 12.

At least either one of R₂₁₄ and R₂₁₅ is preferably an alkyl group, and more preferably, R₂₁₄ and R₂₁₅ both are an alkyl group.

In formula (B2), the aryl group of R₂₀₄ and R₂₀₅ is preferably a phenyl group or a naphthyl group, more preferably a phenyl group.

The alkyl group of R₂₀₄ and R₂₀₅ may be either linear or branched and is preferably a linear or branched alkyl group having a carbon number of 1 to 10 (e.g., methyl, ethyl, propyl, butyl, pentyl).

The cycloalkyl group of R₂₀₄ and R₂₀₅ is preferably a cycloalkyl group having a carbon number of 3 to 10 (e.g., cyclopentyl, cyclohexyl, norbornyl).

R₂₀₄ and R₂₀₅ each may have a substituent, and examples of the substituent which R₂₀₄ and R₂₀₅ each may have include an alkyl group (for example, an alkyl group having a carbon number of 1 to 15), a cycloalkyl group (for example, a cycloalkyl group having a carbon number of 3 to 15), an aryl group (for example, an aryl group having a carbon number of 6 to 15), an alkoxy group (for example, an alkoxy group having a carbon number of 1 to 15), a halogen atom, a hydroxyl group and a phenylthio group.

The cation structure is preferably a structure represented by formula (B1), more preferably a structure represented by any one of formulae (B1a) to (B1c).

Specific examples of the compound capable of generating an acid upon irradiation with actinic rays or radiation, represented by formula (II) or (II'), are set forth below, but the present invention is not limited thereto.

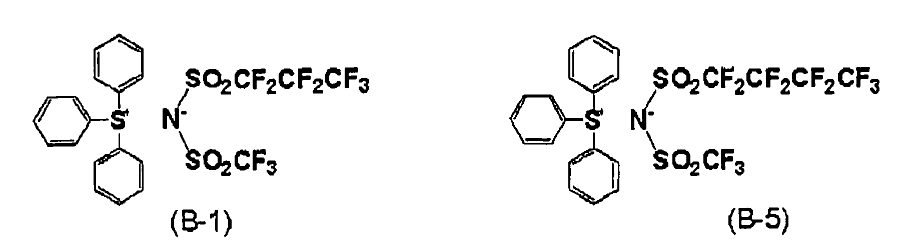

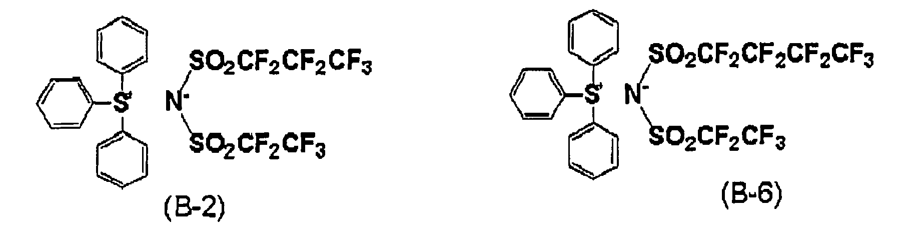

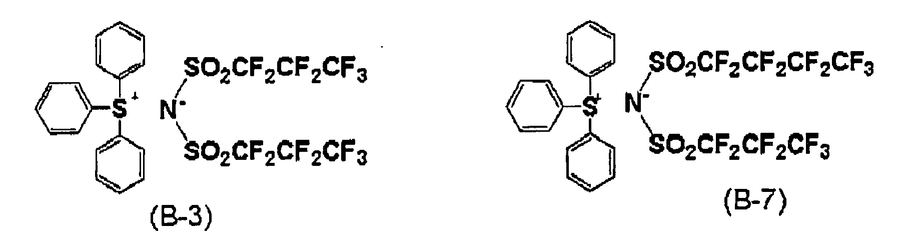

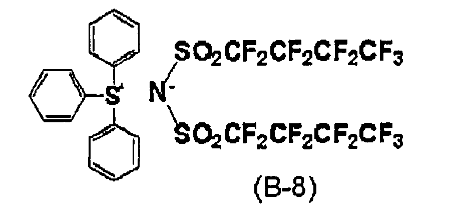

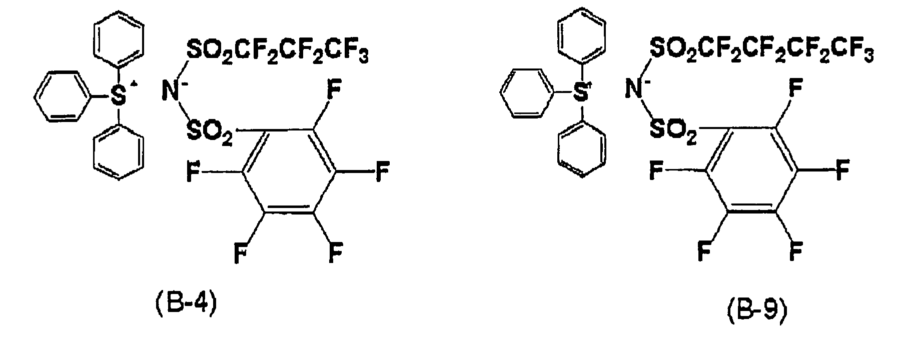

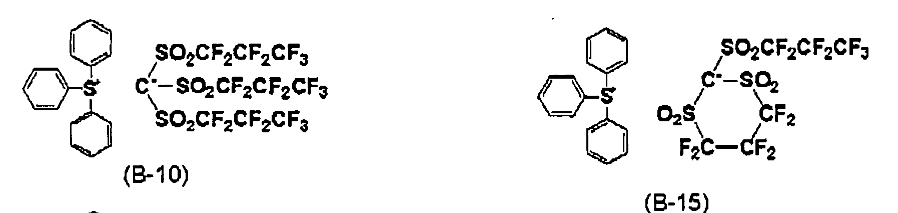

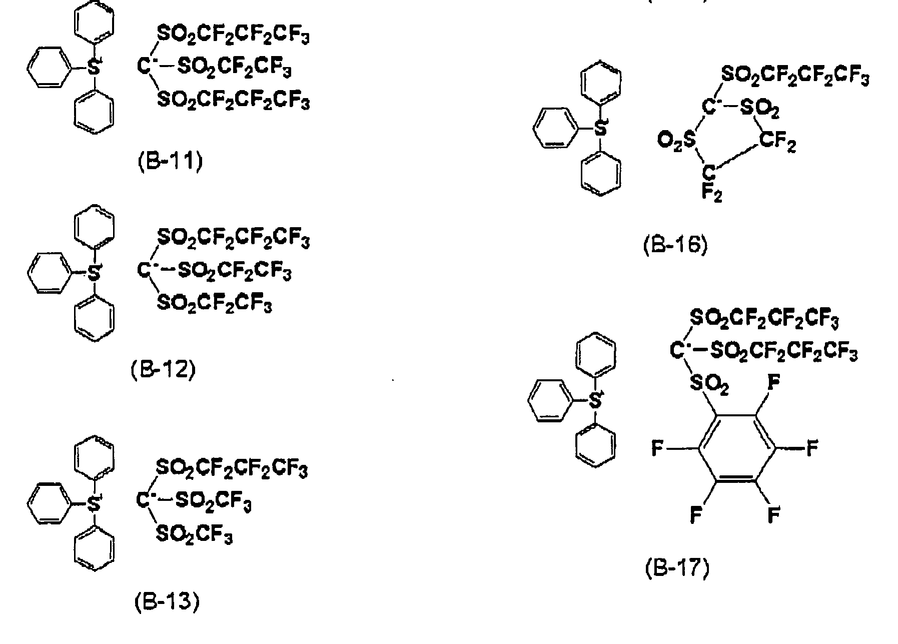

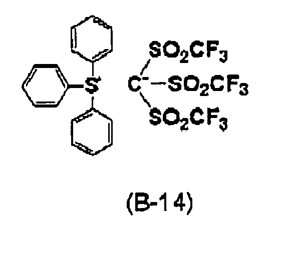

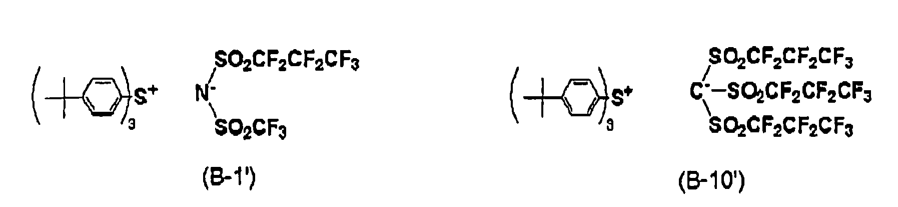

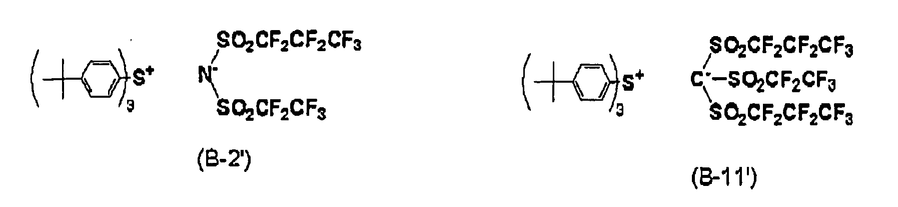

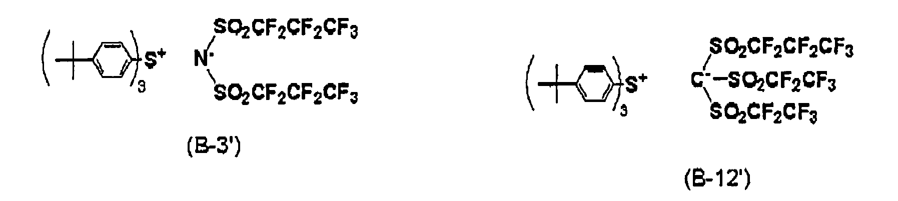

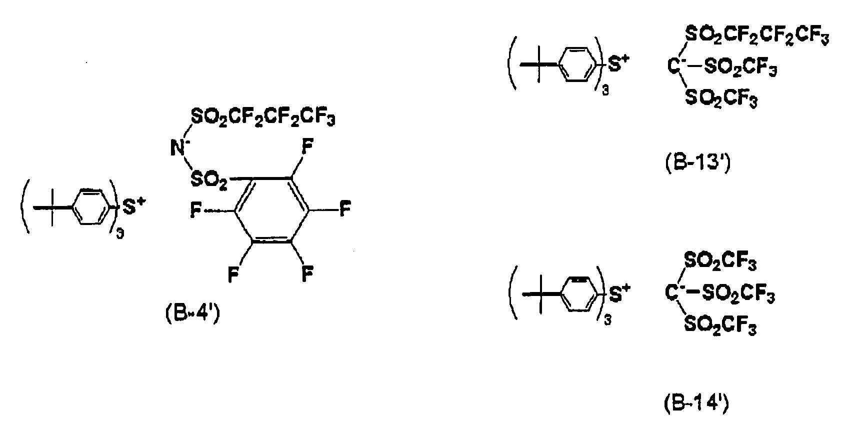

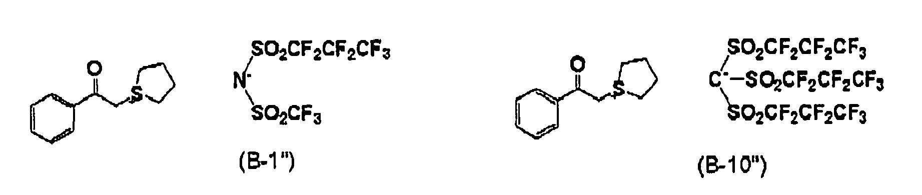

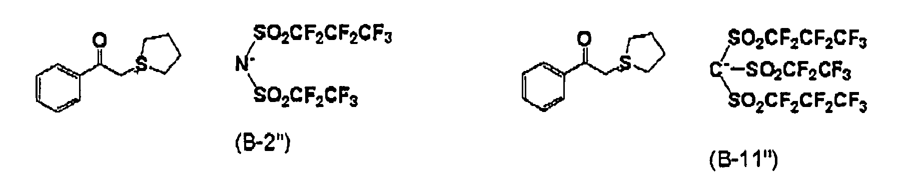

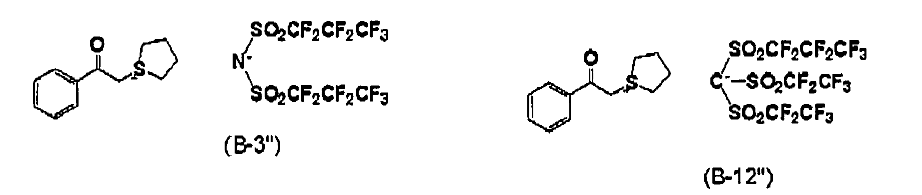

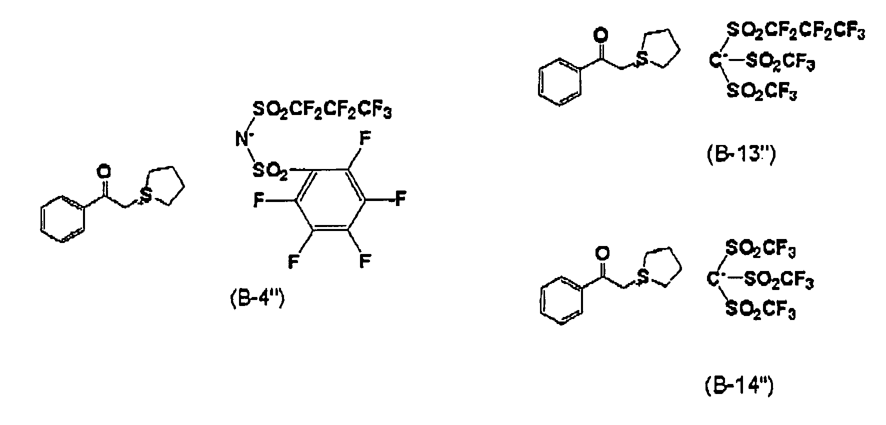

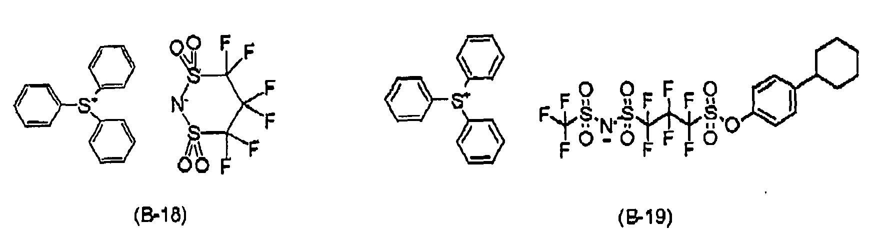

The acid compound or lithium, sodium or potassium salt of the anion component of the compound represented by formula (II) or (II') can be easily synthesized by using the method described in U.S. Patent 5,554,664. Also, some are available from SynQuest Laboratories, Inc., Hydrus Chemical Inc., Azmax Co, and the like.

The compound (B) can be easily synthesized from an acid compound or lithium, sodium or potassium salt of the anion component of the compound represented by formula (II) or (II') and a hydroxide, bromide, chloride or the like of iodonium cation or sulfonium cation by using a salt exchange process described in JP-T-11-501909, JP-A-2003-246786, JP-A-2004-26789 or JP-A-2004-12554.

The content of the compound (B) in the photosensitive composition of the present invention is preferably from 0.1 to 20 mass%, more preferably from 0.5 to 10 mass%, still more preferably from 1 to 7 mass%, based on the solid content of the composition.

### [2] (C) Acid Generator Used in Combination

In the present invention, other than the compound (B), (C) a compound capable of decomposing upon irradiation with actinic rays or radiation to generate an acid may be further used in combination.

The amount added of the other acid generator which can be used in combination is, in terms of the molar ratio (compound (B)/compound (C)), usually from 100/0 to 20/80, preferably from 100/0 to 40/60, more preferably from 100/0 to 50/50.

As for such an acid generator usable in combination, a photoinitiator for photocationic polymerization, a photoinitiator for photoradical polymerization, a photo-decoloring agent for coloring matters, a photo-discoloring agent, a known compound capable of generating an acid upon irradiation with actinic rays or radiation, which is used for microresist and the like, or a mixture thereof may be appropriately selected and used.

Examples thereof include diazonium salt, phosphonium salt, sulfonium salt, iodonium salt, imidosulfonate, oxime sulfonate, diazodisulfone, disulfone and o-nitrobenzyl sulfonate.

Also, a compound where such a group or compound capable of generating an acid upon irradiation with actinic rays or radiation is introduced into the main or side chain of a polymer may be used, and examples thereof include the compounds described in U.S. Patent 3,849,137, German Patent 3,914,407, JP-A-63-26653, JP-A-55-164824, JP-A-62-69263, JP-A-63-146038, JP-A-63-163452, JP-A-62-153853 and JP-A-63-146029.

Furthermore, compounds capable of generating an acid by the effect of light described, for example, in U.S. Patent 3,779,778 and European Patent 126,712 may also be used.

Among the acid generators which may be used in combination, the compounds represented by the following formulae (C1), (C2) and (C3) are preferred.

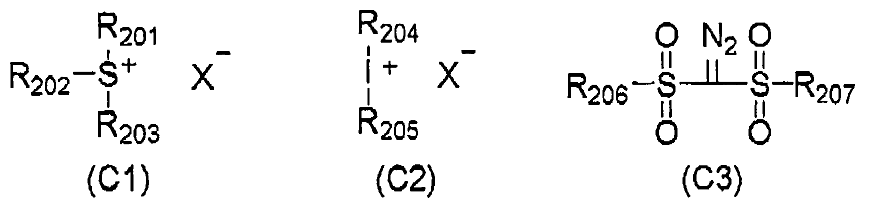

In formula (C1), R₂₀₁, R₂₀₂ and R₂₀₃ each independently represents an organic group.

The carbon number of the organic group as R₂₀₁, R₂₀₂ and R₂₀₃ is generally from 1 to 30, preferably from 1 to 20.

Two members out of R₂₀₁ to R₂₀₃ may combine to form a ring structure, and the ring may contain an oxygen atom, a sulfur atom, an ester bond, an amide bond or a carbonyl group.

Examples of the group formed resulting from two members out of R₂₀₁ to R₂₀₃ being combined include an alkylene group (e.g., butylene, pentylene).

X' represents a non-nucleophilic anion.

Examples of the non-nucleophilic anion of X' include sulfonate anion, carboxylate anion, sulfonylimide anion, bis(alkylsulfonyl)innxde anion and tris(alk-ylsulfonyl)methyl anion.

The non-nucleophilic anion is an anion having an extremely low ability of causing a nucleophilic reaction, and this anion can suppress the decomposition in aging due to intramolecular nucleophilic reaction. By virtue of this anion, the aging stability of the resist can be enhanced.

Examples of the sulfonate anion include an aliphatic sulfonate anion, an aromatic sulfonate anion and a camphorsulfonate anion.

Examples of the carboxylate anion include an aliphatic carboxylate anion, an aromatic carboxylate anion and an aralkyloar6oxylate anion.

The aliphatic moiety in the aliphatic sulfonate anion may be an alkyl group or a cycloalkyl group and is preferably an alkyl group having a carbon number of 1 to 30 or a cycloalkyl group having a carbon number of 3 to 30, and examples thereof include a methyl group, an ethyl group, a propyl group, an isopropyl group, an n-butyl group, an isobutyl group, a sec-butyl group, a pentyl group, a neopentyl group, a hexyl group, a heptyl group, an octyl group, a nonyl group, a decyl group, an undecyl group, a dodecyl group, a tridecyl group, a tetradecyl group, a pentadecyl group, a hexadecyl group, a heptadecyl group, an octadecyl group, a nonadecyl group, an eicosyl group, a cyclopropyl group, a cyclopentyl group, a cyclohexyl group, an adamantyl group, a norbornyl group and a boronyl group.

The aryl group in the aromatic sulfonate anion is preferably an aryl group having a carbon number of 6 to 14, and examples thereof include a phenyl group, a tolyl group and a naphthyl group.

Examples of the substituent for the alkyl group, cycloalkyl group and aryl group in the aliphatic sulfonate anion and aromatic sulfonate anion include a nitro group, a halogen atom (e.g., fluorine, chlorine, bromine, iodine), a carboxyl group, a hydroxyl group, an amino group, a cyano group, an alkoxy group (preferably having a carbon number of 1 to 5), a cycloalkyl group (preferably having a carbon number of 3 to 15), an aryl group (preferably having a carbon number of 6 to 14), an alkoxycarbonyl group (preferably having a carbon number of 2 to 7), an acyl group (preferably having a carbon number of 2 to 12), and an alkoxycarbonyloxy group (preferably having a carbon number of 2 to 7). As for the aryl group or ring structure in each group, examples of the substituent further include an alkyl group (preferably having a carbon number of 1 to 15).

Examples of the aliphatic moiety in the aliphatic carboxylate anion include the same alkyl group and cycloalkyl group as those in the aliphatic sulfonate anion.

Examples of the aryl group in the aromatic carboxylate anion include the same aryl group as those in the aromatic sulfonate anion.

The aralkyl group in the aralkylcarboxylate anion is preferably an aralkyl group having a carbon number of 6 to 12, and examples thereof include a benzyl group, a phenethyl group, a naphthylethyl group and a naphthylmethyl group.

Examples of the substituent for the alkyl group, cycloalkyl group, aryl group and aralkyl group in the aliphatic carboxylate anion, aromatic carboxylate anion and aralkylcarboxylate anion include the same halogen atom, alkyl group, cycloalkyl group, alkoxy group and alkylthio group as those in the aromatic sulfonate anion.

Examples of the sulfonylimide anion include saccharine anion.

The alkyl group in the bis(alkylsulfonyl)imide anion and tris(alkylsulfonyl)methyl anion is preferably an alkyl group having a carbon number of 1 to 5, and examples thereof include a methyl group, an ethyl group, a propyl group, an isopropyl group, an n-butyl group, an isobutyl group, a sec-butyl group, a pentyl group and a neopentyl group. Examples of the substituent for this alkyl group include a halogen atom, a halogen atom-substituted alkyl group, an alkoxy group and an alkylthio group, with a fluorine atom-substituted alkyl group being preferred.

Other examples of the non-nucleophilic anion include fluorinated phosphorus, fluorinated boron and fluorinated antimony.

The non-nucleophilic anion of X⁻ is preferably an aliphatic sulfonate anion with the a-position of the sulfonic acid being substituted by a fluorine atom, an aromatic sulfonate anion substituted by a fluorine atom or a fluorine atom-containing group, a bis(alkylsulfonyl)imide anion with the alkyl group being substituted by a fluorine atom, or a tris(alkylsulfonyl)methide anion with the alkyl group being substituted by a fluorine atom. The non-nucleophilic anion is more preferably a perfluoro aliphatic sulfonate anion having a carbon number of 4 to 8, or a fluorine atom-containing benzenesulfonate anion, and most preferably nonafluorobutanesulfonate anion, perfluorooetanesulfonate anion, pentafluorobenzenesulfonate anion or 3,5-bis(trifluoromethyl)benzenesulfonate anion.

Examples of the organic group of R₂₀₁, R₂₀₂ and R₂₀₃ include corresponding groups in the compounds (C1-1), (C1-2) and (C1-3) which are described later.

The compound may be a compound having a plurality of structures represented by formula (C1), for example, may be a compound having a structure where at least one ofR₂₀₁ to R₂₀₃ in the compound represented by formula (C1) is bonded to at least one of R₂₀₁ to R₂₀₃ in another compound represented by formula (C1).

The preferred compound as the component (C1) includes the compounds (C1-1), (C1-2) and (C1-3) described below.

The compound (C1-1) is an arylsulfonium compound where at least one of R₂₀₁ to R₂₀₃ in formula (C1) is an aryl group, that is, a compound having an arylsulfonium as the cation.

In the arylsulfonium compound, R₂₀₁ to R₂₀₃ all may be an aryl group or a part of R₂₀₁ to R₂₀₃ may be an aryl group with the remaining being an alkyl group or a cycloalkyl group.

Examples of the arylsulfonium compound include a triarylsulfonium compound, a diarylalkylsulfonium compound, an aryldialkylsulfonium compound, a diarylcycloalkyl compound and an aryldicycloalkyl compound.

The aryl group in the arylsulfonium compound is preferably a phenyl group or a naphthyl group, more preferably a phenyl group. In the case where the arylsulfonium compound has two or more aryl groups, these two or more aryl groups may be the same of different.

The alkyl group or cycloalkyl group which is present, if desired, in the arylsulfonium compound is preferably a linear or branched alkyl group having a carbon number of 1 to 15 or a cycloalkyl group having a carbon number of 3 to 15, and examples thereof include a methyl group, an ethyl group, a propyl group, an n-butyl group, a sec-butyl group, a tert-butyl group, a cyclopropyl group, a cyclobutyl group and a cyclohexyl group.

The aryl group, alkyl group and cycloalkyl group of R₂₀₁ to R₂₀₃ each may have, as the substituent, an alkyl group (for example, an alkyl group having a carbon number of 1 to 15), a cycloalkyl group (for example, a cycloalkyl group having a carbon number of 3 to 15), an aryl group (for example, an aryl group having a carbon number of 6 to 14), an alkoxy group (for example, an alkoxy group having a carbon number of 1 to 15), a halogen atom, a hydroxyl group or a phenylthio group. The substituent is preferably a linear or branched alkyl group having a carbon number of 1 to 12, a cycloalkyl group having a carbon number of 3 to 12, or a linear, branched or cyclic alkoxy group having a carbon number of 1 to 12, and most preferably an alkyl group having a carbon number of 1 to 4, or an alkoxy group having a carbon number of 1 to 4. The substituent may be substituted to any one of three members R₂₀₁ to R₂₀₃ or may be substituted to all of these three members. In the case where R₂₀₁ to R₂₀₃ each is an aryl group, the substituent is preferably substituted at the p-position of the aryl group.

The structure (C1-2) is described below.

The structure (C1-2) is a compound where R₂₀₁ to R₂₀₃ in formula (C1) each independently represents an organic group not containing an aromatic ring. The aromatic ring as used herein includes an aromatic ring having a heteroatom.

The aromatic ring-free organic group of R₂₀₁ to R₂₀₃ has a carbon number of generally from 1 to 30, preferably from 1 to 20.

R₂₀₁ to R₂₀₃ each independently represents preferably an alkyl group, a cycloalkyl group, an allyl group or a vinyl group, more preferably a linear or branched 2-oxoalkyl group, a 2-oxocycloalkyl group or an alkoxycarbonylmethyl group, and most preferably a linear or branched 2-oxoalkyl group.

The alkyl group or cycloalkyl group of R₂₀₁ to R₂₀₃ is preferably a linear or branched alkyl group having a carbon number of 1 to 10 (e.g., methyl, ethyl, propyl, butyl, pentyl) or a cycloalkyl group having a carbon number of 3 to 10 (e.g., cyclopentyl, cyclohexyl, norbornyl). The alkyl group is more preferably a 2-oxoalkyl group or an alkoxycarbonylmethyl group. The cycloalkyl group is more preferably a 2-oxocycloalkyl group.

The 2-oxoalkyl group may be linear or branched and is preferably a group having >C=O at the 2-position of the alkyl group above.

The 2-oxocycloalkyl group is preferably a group having >C=O at the 2-position of the cycloalkyl group above.

The alkoxy group in the alkoxycarbonylmethyl group is preferably an alkoxy group having a carbon number of 1 to 5 (e.g., methoxy, ethoxy, propoxy, butoxy, pentoxy).

R₂₀₁ to R₂₀₃ each may be further substituted by a halogen atom, an alkoxy group (for example, an alkoxy group having a carbon number of 1 to 5), a hydroxyl group, a cyano group or a nitro group.

The compound (C1-3) is a compound represented by the following formula (C1-3), and this is a compound having a phenacylsulfonium salt structure.

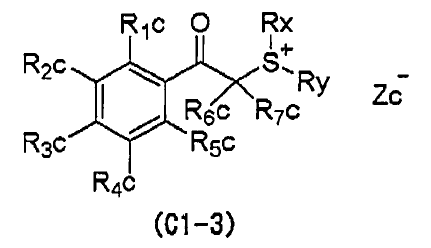

R_{1c} to R_{5c} each independently represents a hydrogen atom, an alkyl group, a cycloalkyl group, an alkoxy group or a halogen atom.

R_{6c} and R_{7c} each independently represents a hydrogen atom, an alkyl group or a cycloalkyl group.

Rₓ and R_{y} each independently represents an alkyl group, a cycloalkyl group, an allyl group or a vinyl group.

Any two or more members out of R_{1c} to R_{5c}, the pair of R_{6c} and R_{7c}, or the pair of Rₓ and R_{y} may combine with each other to form a ring structure, and examples of the group formed resulting from these being combined include a butylene group and a pentylene group. The ring structure may contain an oxygen atom, a sulfur atom, an ester bond or an amide bond.

Zc⁻ represents a non-nucleophilic anion, and examples thereof are the same as those of the non-nucleophilic anion of X⁻ in formula (C1).

The alkyl group of R_{1c} to R_{7c} may be linear or branched and includes, for example, an alkyl group having a carbon number of 1 to 20, preferably a linear or branched alkyl group having a carbon number of 1 to 12 (e.g., methyl, ethyl, linear or branched propyl, linear or branched butyl, linear or branched pentyl). The cycloalkyl group includes, for example, a cycloalkyl group having a carbon number of 3 to 8 (e.g., cyclopentyl, cyclohexyl).

The alkoxy group of R_{1c} to R_{5c} may be linear, branched or cyclic and includes, for example, an alkoxy group having a carbon number of 1 to 10, preferably a linear or branched alkoxy group having a carbon number of 1 to 5 (e.g., methoxy, ethoxy, linear or branched propoxy, linear or branched butoxy, linear or branched pentoxy), and a cyclic alkoxy group having a carbon number of 3 to 8 (e.g., cyclopentyloxy, cyclohexyloxy).

A compound where any one of R_{1c} to R_{5c} is a linear or branched alkyl group, a cycloalkyl group or a linear, branched or cyclic alkoxy group is preferred, and a compound where the sum of carbon numbers of R_{1c} to R_{5c} is from 2 to 15 is more preferred. In this case, the solubility in a solvent is more enhanced, and production of particles during storage can be suppressed.

Examples of the alkyl group and cycloalkyl group of Rₓ and R_{y} are the same as those of the alkyl group and cycloalkyl group of R_{1c} to R_{7c}. Among these, a 2-oxoalkyl group, a 2-oxocycloalkyl group and an alkoxycarbonylmethyl group are preferred.

Examples of the 2-oxoalkyl group and 2-oxocycloalkyl group include a group having >C=O at the 2-position of the alkyl or cycloalkyl group of R_{1c} to R_{7c}.

Examples of the alkoxy group in the alkoxycarbonylmethyl group are the same as those of the alkoxy group of R_{1c} to R_{5c}.

Rₓ and R_{y} each is preferably an alkyl group or cycloalkyl group having a carbon number of 4 or more, more preferably 6 or more, still more preferably 8 or more.

In formulae (C2) and (C3), R₂₀₄ to R₂₀₇ each independently represents an aryl group, an alkyl group or a cycloalkyl group.

The aryl group of R₂₀₄ to R₂₀₇ is preferably a phenyl group or a naphthyl group, more preferably a phenyl group.

The alkyl group or cycloalkyl group of R₂₀₄ and R₂₀₇ is preferably a linear or branched alkyl group having a carbon number of 1 to 10 (e.g., methyl, ethyl, propyl, butyl, pentyl), or a cycloalkyl group having a carbon number of 3 to 10 (e.g., cyclopentyl, cyclohexyl, norbornyl).

Examples of the substituent which R₂₀₄ to R₂₀₇ each may have include an alkyl group (for example, an alkyl group having a carbon number of 1 to 15), a cycloalkyl group (for example, a cycloalkyl group having a carbon number of 3 to 15), an aryl group (for example, an aryl group having a carbon number of 6 to 15), an alkoxy group (for example, an alkoxy group having a carbon number of 1 to 15), a halogen atom, a hydroxyl group and a phenylthio group.

X⁻ represents a non-nucleophilic anion, and examples thereof are the same as those of the non-nucleophilic anion of X⁻ in formula (C1).

Specific examples of (C) the compound capable generating an acid upon irradiation with actinic rays or radiation are set forth below, but the present invention is not limited thereto.

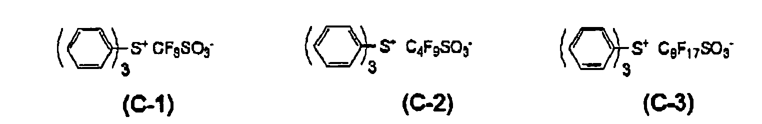

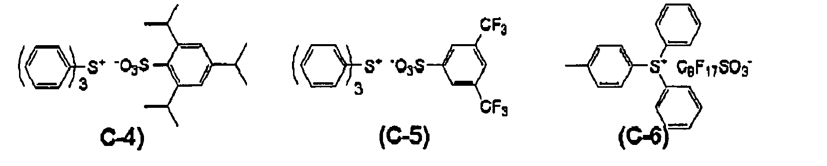

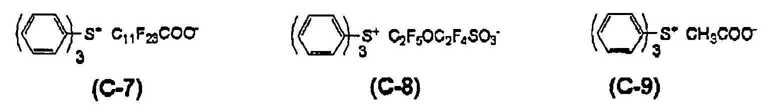

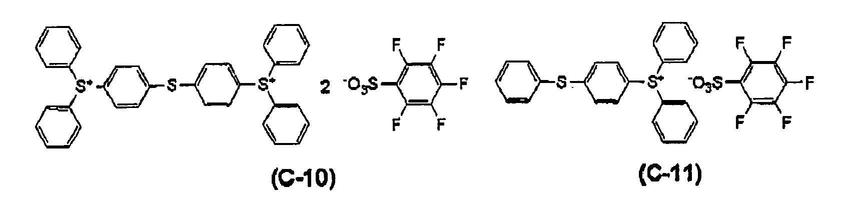

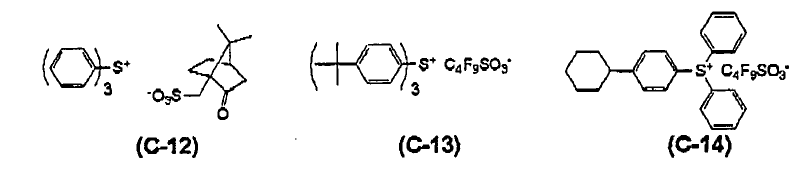

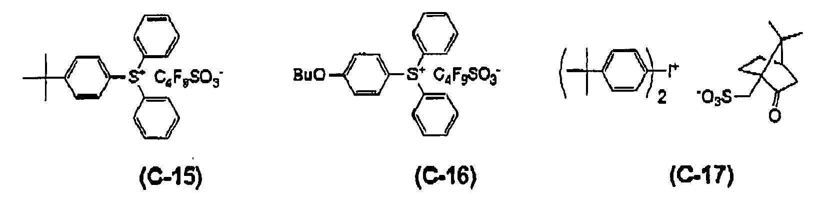

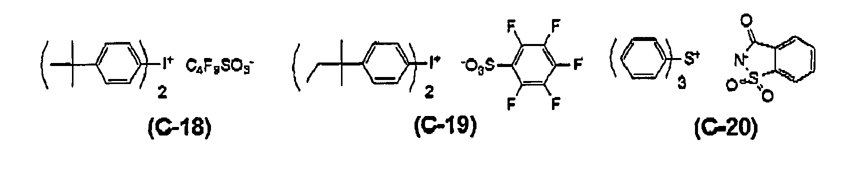

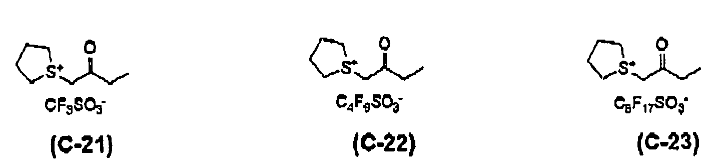

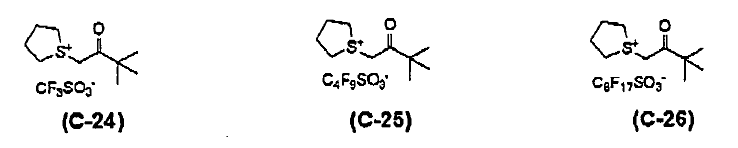

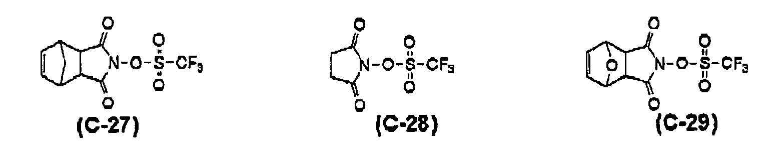

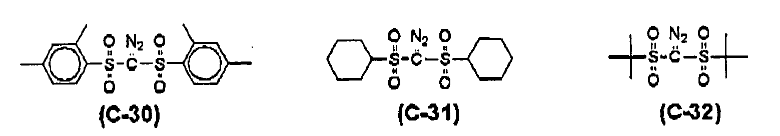

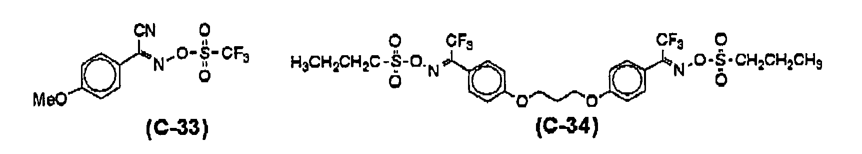

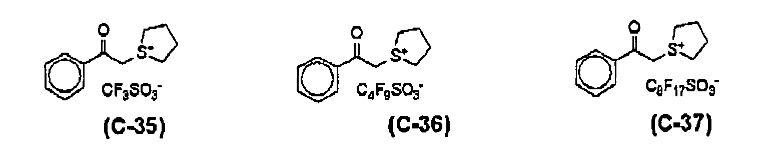

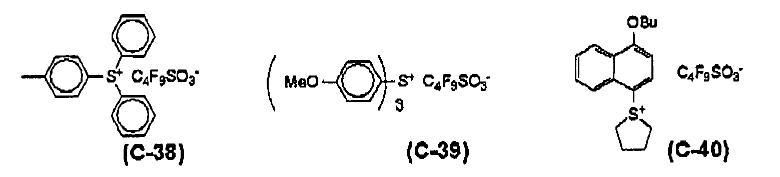

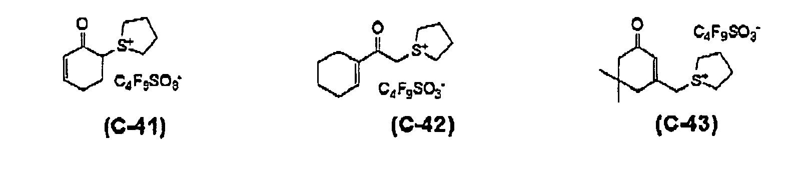

### [3] Organic basic compound

In the present invention, an organic basic compound is preferably used from the standpoint of, for example, enhancing the performance such as resolving power or the storage stability. The organic basic compound is more preferably a compound containing a nitrogen atom (nitrogen-containing basic compound).

The organic basic compound preferred in the present invention is a compound having basicity stronger than that of phenol.

Preferred chemical environments thereof include structures of the following formulae (A) to (E). The structures of formulae (B) to (E) each may be a part of a ring structure.

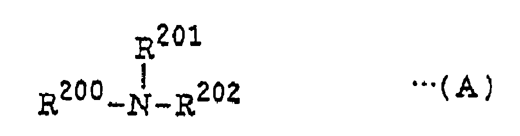

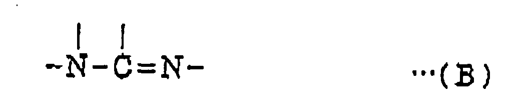

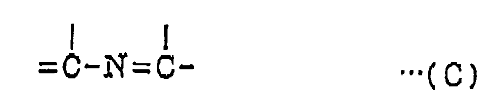

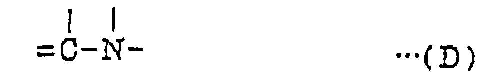

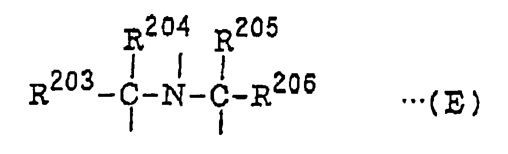

In formula (A), R²⁰⁰, R²⁰¹ and R²⁰², which may be the same or different, each represents a hydrogen atom, an alkyl group (preferably having a carbon number of 1 to 20), a cycloalkyl group (preferably having a carbon number of 3 to 20) or an aryl group (preferably having a carbon number of 6 to 20), and R²⁰¹ and R²⁰² may combine with each other to form a ring.

The alkyl group, cycloalkyl group and aryl group as R²⁰⁰, R²⁰¹ and R²⁰² each may have a substituent. The alkyl group or cycloalkyl group having a substituent is preferably an aminoalkyl group or aminocycloalkyl group having a carbon number of 1 to 20 or a hydroxyalkyl group having a carbon number of 1 to 20.

In formula (E), R²⁰³, R²⁰⁴, R²⁰⁵ and R²⁰⁶, which may be the same or different, each represents an alkyl group having a carbon number of 1 to 6 or a cycloalkyl group.

The compound is more preferably a nitrogen-containing basic compound having two or more nitrogen atoms differing in the chemical environment within one molecule, still more preferably a compound containing both a substituted or unsubstituted amino group and a nitrogen-containing ring structure, or a compound having an alkylamino group.

Specific preferred examples thereof include guanidine, aminopyridine, aminoalkylpyridine, aminopyrrolidine, indazole, imidazole, pyrazole, pyrazine, pyrimidine, purine, imidazoline, pyrazoline, piperazine, aminomorpholine and aminoalkylmorpholine. Preferred examples of the substituent which these compounds may have include an amino group, an alkylamino group, an aminoaryl group, an arylamino group, an alkyl group (as the substituted alkyl group, an aminoalkyl group in particular), an alkoxy group, an acyl group, an acyloxy group, an aryl group, an aryloxy group, a nitro group, a hydroxyl group and a cyano group.

More preferred examples of the compound include, but are not limited to, guanidine, 1,1-dimethylguanidine, 1,1,3,3-tetramethylguanidine, imidazole, 2-methylimidazole, 4-methylimidazole, N-methylimidazole, 2-phenylimidazole, 4,5-diphenylimidazole, 2,4,5-triphenylimidazole, 2-aminopyridine, 3-aminopyridine, 4-aminopyridine, 2-dimethylaminopyridine, 4-dimethylaminopyridine, 2-diethylaminopyridine, 2-(aminomethyl)pyridine, 2-amino-3-methylpyridine, 2-amino-4-methylpyridine, 2-amino-5-methylpyridine, 2-amino-6-methylpyridine, 3-aminoethylpyridine, 4-aminoethylpyridine, 3-aminopyrrolidine, piperazine, N-(2-aminoethyl)piperazine, N-(2-aminoethyl)piperidine, 4-amino-2,2,6,6-tetramethylpiperidine, 4-piperidinopiperidine, 2-iminopiperidine, 1-(2-aminoethyl)pyrrolidine, pyrazole, 3-amino-5-methylpyrazole, 5-amino-3-methyl-1-p-tolylpyrazole, pyrazine, 2-(aminomethyl)-5-methylpyrazine, pyrimidine, 2,4-diaminopyrimidine, 4,6-dihydroxypyrimidine, 2-pyrazoline, 3-pyrazoline, N-aminomorpholine and N-(2-aminoethyl)morpholine.

One of these nitrogen-containing basic compounds may be used alone, or two or more species thereof may be used in combination.

A tetraalkylammonium salt-type nitrogen-containing basic compound may also be used. Among such compounds, a tetraalkylammonium hydroxide having a carbon number of 1 to 8 (e.g., tetramethylammonium hydroxide, tetraethylammonium hydroxide, tetra-(n-butyl)ammonium hydroxide) is preferred. One of these nitrogen-containing basic compounds may be used alone, or two or more species thereof may be used in combination.

As for the ratio between the acid generator and the organic basic compound used in the composition, the (total amount of acid generator)/(organic basic compound) (ratio by mol) is preferably from 2.5 to 300. When this molar ratio is 2.5 or more, high sensitivity is obtained, and when the molar ratio is 300 or less, the resist pattern can be prevented from thickening in aging after exposure until heat treatment and the resolving power can be enhanced. The (total amount of acid generator)/(organic basic compound) (ratio by mol) is more preferably from 5.0 to 200, still more preferably from 7.0 to 150.

### [4] Surfactants

In the present invention, surfactants can be used and use thereof is preferred in view of film-forming property, adhesion of pattern and reduction in development deficiency.

Specific examples of the surfactant include a nonionic surfactant such as polyoxyethylene alkyl ethers (e.g., polyoxyethylene lauryl ether, polyoxyethylene stearyl ether, polyoxyethylene cetyl ether, polyoxyethylene oleyl ether), polyoxyethylene alkylallyl ethers (e.g., polyoxyethylene octylphenol ether, polyoxyethylene nonylphenol ether), polyoxyethylene•polyoxypropylene block copolymers, sorbitan fatty acid esters (e.g., sorbitan monolaurate, sorbitan monopalmitate, sorbitan monostearate, sorbitan monooleate, sorbitan trioleate, sorbitan tristearate) and polyoxyethylene sorbitan fatty acid esters (e.g., polyoxyethylene sorbitan monolaurate, polyoxyethylene sorbitan monopalmitate, polyoxyethylene sorbitan monostearate, polyoxyethylene sorbitan trioleate, polyoxyethylene sorbitan tristearate); a fluorine-containing surfactant and a silicon-containing surfactant, such as EFtop EF301, EF303 and EF352 (produced by Shin-Akita Chemical Co., Ltd.), Megafac F171 and F173 (produced by Dainippon Ink & Chemicals, Inc.), Florad FC430 and FC431 (produced by Surnitomo 3M Inc.), Asahiguard AG710, Surflon S-382, SC101, SC102, SC103, SC104, SC105 and SC106 (produced by Asahi Glass Co., Ltd.), and Troysol S-366 (produced by Troy Chemical Industries, Inc.); an organosiloxane polymer, KP-341 (produced by Shin-Etsu Chemical Co., Ltd.); and acrylic acid-based or methacrylic acid-based (co)polymers, Polyflow No. 75 and No. 95 (produced by Kyoeisha Yushi Kagaku Kogyo Co., Ltd.). The blending amount of such a surfactant is usually 2 parts by mass or less, preferably 1 part by mass or less, per 100 parts by mass of the solid content in the composition of the present invention.

One of these surfactants may be used alone or several species thereof may be added in combination.

As for the surfactant, the composition preferably contains any one species of fluorine- and/or silicon-containing surfactants (a fluorine-containing surfactant, a silicon-containing surfactant or a surfactant containing both a fluorine atom and a silicon atom), or two or more species thereof.

Examples of these surfactants include the surfactants described in JP-A-62-36663, JP-A-61-226746, JP-A-61-226745, JP-A-62-170950, JP-A-63-34540, JP-A-7-230165, JP-A-8-62834, JP-A-9-54432, JP-A-9-5988, JP-A-2002-277862 and U.S. Patents 5,405,720, 5,360,692, 5,529,881, 5,296,330, 5,436,098, 5,576,143, 5,294,511 and 5,824,451. The following commercially available surfactants each may also be used as it is.

Examples of the commercially available surfactant which can be used include a fluorine-containing or silicon-containing surfactant such as EFtop EF301 and EF303 (produced by Shin-Akita Chemical Co., Ltd.), Florad FC430 and 431 (produced by Sumitomo 3M Inc.), Megafac F171, F173, F176, F189 and R08 (produced by Dainippon Ink & Chemicals, Inc.), Surflon S-382, SC101, 102, 103, 104, 105 and 106 (produced by Asahi Glass Co., Ltd.), and Troysol S-366 (produced by Troy Chemical Industries, Inc.). In addition, a polysiloxane polymer, KP-341 (produced by Shin-Etsu Chemical Co., Ltd.), may also be used as the silicon-containing surfactant.

Other than these known surfactants, a surfactant using a polymer having a fluoroaliphatic group which is derived from a fluoroaliphatic compound produced by a telomerization process (also called a telomer process) or an oligomerization process (also called an oligomer process), may be used. The fluoroaliphatic compound can be synthesized by the method described in JP-A-2002-90991.

The polymer having a fluoroaliphatic group is preferably a copolymer of a fluoroaliphatic group-containing monomer with a (poly(oxyalkylene)) acrylate and/or a (poly(oxyalkylene)) methacrylate, and the polymer may have an irregular distribution or may be a block copolymer. Examples of the poly(oxyalkylene) group include a poly(oxyethylene) group, a poly(oxypropylene) group and a poly(oxybutylene) group. This group may also be a unit having alkylenes differing in the chain length within the same chain, such as block-linked poly(oxyethylene, oxypropylene and oxyethylene) and block-linked poly(oxyethylene and oxypropylene). Furthermore, the copolymer of a fluoroaliphatic group-containing monomer with a (poly(oxyalkylene)) acrylate (or methacrylate) may be not only a binary copolymer but also a ternary or higher copolymer obtained by simultaneously copolymerizing two or more different fluoroaliphatic group-containing monomers or two or more different (poly(oxyalkylene)) acrylates (or methacrylates).

Examples thereof include commercially available surfactants such as Megafac F178, F-470, F-473, F-475, F-476 and F-472 (produced by Dainippon Ink & Chemicals, Inc.), and further include a copolymer of a C₆F₁₃ group-containing acrylate (or methacrylate) with a (poly(oxyalkylene)) acrylate (or methacrylate), a copolymer of a C₆F₁₃ group-containing acrylate (or methacrylate) with (poly(oxyethylene)) acrylate (or methacrylate) and (poly(oxypropylene)) acrylate (or methacrylate), a copolymer of a C₈F₁₇ group-containing acrylate (or methacrylate) with a (poly(oxyalkylene)) acrylate (or methacrylate), and a copolymer of a C₈F₁₇ group-containing acrylate (or methacrylate) with (poly(oxyethylene)) acrylate (or methacrylate) and (poly(oxypropylene)) acrylate (or methacrylate).

The amount of the surfactant used is preferably from 0.0001 to 2 mass%, more preferably from 0.001 to 1 mass%, based on the entire amount of the resist composition (excluding the solvent).

### [5] Other components

The resist composition of the present invention may further contain, if desired, a dye, a photobase generator and the like.

### 1. Dye

In the present invention, a dye may be used.

The suitable dye includes an oily dye and a basic dye. Specific examples thereof include Oil Yellow #101, Oil Yellow #103, Oil Pink #312, Oil Green BG, Oil Blue BOS, Oil Blue #603, Oil Black BY, Oil Black BS, Oil Black T-505 (all produced by Orient Chemical Industries Co., Ltd.), Crystal Violet (CI42555), Methyl Violet (CI42535), Rhodamine B (CI45170B), Malachite Green (CI42000) and Methylene Blue (CI52015).

### 2. Photobase generator

Examples of the photobase generator which can be added to the composition of the present invention include the compounds described in JP-A-4-151156, JP-A-4-162040, JP-A-5-197148, JP-A-5-5995, JP-A-6-194834, JP-A-8-146608, JP-A-10-83079 and European Patent 622,682. Specific examples of the photobase generator which can be suitably used include 2-nitrobenzyl carbamate, 2,5-dinitroben,zylcyclohexyl carbamate, N-cyclohexyl-4-methylphenylsulfonamide and 1,1-dimethyl-2-phenylethyl-N-isopropyl carbamate. Such a photobase generator is added for the purpose of improving the resist profile or the like.

### 3. Solvents

The resist composition of the present invention is dissolved in a solvent capable of dissolving respective components described above and then coated on a support. The resist composition is usually dissolved to a concentration of, in terms of the solid content concentration of all resist components, preferably from 2 to 30 mass%, more preferably from 3 to 25 mass%.

Preferred examples of the solvent used here include ethylene dichloride, cyclohexanone, cyclopentanone, 2-heptanone, γ-butyrolactone, methyl ethyl ketone, ethylene glycol monomethyl ether, ethylene glycol monoethyl ether, 2-methoxyethyl acetate, ethylene glycol monoethyl ether acetate, propylene glycol monomethyl ether, propylene glycol monomethyl ether acetate, toluene, ethyl acetate, methyl lactate, ethyl lactate, methyl methoxypropionate, ethyl ethoxypropionate, methyl pyruvate, ethyl pyruvate, propyl pyruvate, N,N-dimethylformamide, dimethylsulfoxide, N-methylpyrrolidone and tetrahydrofuran. These solvents are used individually or as a mixture.

The resist composition of the present invention is coated on a substrate to form a thin film. The thickness of this coating film is preferably from 0.05 to 4.0 µm.

In the present invention, a commercially available inorganic or organic antireflection film may be used, if desired. Furthermore, the antireflection film may be used by coating it as an underlayer of the resist.

The antireflection film used as the underlayer of the resist may be either an inorganic film type such as titanium, titanium dioxide, titanium nitride, chromium oxide, carbon and amorphous silicon, or an organic film type comprising a light absorbent and a polymer material. The former requires equipment for the film formation, such as vacuum deposition apparatus, CVD apparatus and sputtering apparatus. Examples of the organic antireflection film include a film comprising a diphenylamine derivative/formaldehyde-modified melamine resin condensate, an alkali-soluble resin and a light absorbent described in JP-B-7-69611 (the term "JP-B" as used herein means an "examined Japanese patent publication"), a reaction product of a maleic anhydride copolymer and a diamine-type light absorbent described in U.S. Patent 5,294,680, a film containing a resin binder and a methylolmelamine-based heat crosslinking agent described in JP-A-6-118631, an acrylic resin-type antireflection film containing a carboxylic acid group, an epoxy group and a light absorbing group within the same molecule described in JP-A-6-118656, a film comprising a methylolmelamine and a benzophenone-based light absorbent described in JP-A-8-87115, and a film obtained by adding a low molecular light absorbent to a polyvinyl alcohol resin described in JP-A-8-179509.

Also, the organic antireflection film may be a commercially available organic antireflection film such as DUV-30 Series and DUV-40 Series produced by Brewer Science, Inc.; and AR-2, AR-3 and AR-5 produced by Shipley Co., Ltd.

In the production or the like of a precision integrated circuit device, the step of forming a pattern on a resist film is performed by coating the resist composition of the present invention on a substrate (for example, a silicon/silicon dioxide-coated substrate, a glass substrate, an ITO substrate or a quartz/chromium oxide-coated substrate) to form a resist film, irradiating thereon actinic rays or radiation such as KrF excimer laser light, electron beam or EUV light, and then subjecting the resist film to heating, development, rinsing and drying, whereby a good resist pattern can be formed.

The alkali developer which can be used in the development is an aqueous solution of alkalis (usually, from 0.1 to 20 mass%) such as inorganic alkalis (e.g., sodium hydroxide, potassium hydroxide, sodium carbonate, sodium silicate, sodium metasilicate, aqueous ammonia), primary amines (e.g., ethylamine, n-propylamine), secondary amines (e.g., diethylamine, di-n-butylamine), tertiary amines (e.g., triethylamine, methyldiethylamine), alcohol amines (e.g., dimethylethanolamine, triethanolamine), quaternary ammonium salts (e.g., tetramethylammonium hydroxide, tetraethylammonium hydroxide, choline) and cyclic amines (e.g., pyrrole, piperidine). This aqueous solution of alkalis may be used after adding thereto alcohols such as isopropyl alcohol or a surfactant such as nonionic surfactant, in an appropriate amount.

Among these developers, a quaternary ammonium salt is preferred, and tetramethylammonium hydroxide and choline are more preferred.

The pH of the alkali developer is usually from 10 to 15.

### [Examples]

The present invention is described in greater detail below by referring to Examples, but the present invention should not be construed as being limited thereto.

### [Synthesis Example 1: synthesis of Resin A-1 as resin (A)]:

Acetoxystyrene and 1-phenylethyl methacrylate were charged at a ratio of 70/30 (by mol) and dissolved in tetrahydrofuran to prepare 100 ml of a solution having a solid content concentration of 20 mass%. Subsequently, 2 mol% of a polymerization initiator, V-65, produced by Wako Pure Chemical Industries, Ltd. was added thereto, and the resulting solution was added dropwise to 10 ml of tetrahydrofuran heated at 60°C, over 4 hours in a nitrogen atmosphere. After the completion of dropwise addition, the reaction solution was heated for 4 hours, and 1 mol% of V-65 was again added, followed by stirring for 4 hours. After the completion of reaction, the reaction solution was cooled to room temperature and then crystallized from 3 L of hexane, and the precipitated white powder was collected by filtration.

The compositional ratio of the polymer determined from C¹³NMR was 69/31 (by mol). Also, the weight average molecular weight determined by GPC was 9,500 in terms of standard polystyrene.

This polymer was dissolved in 100 ml of tetrahydrofuran, 5 ml of TMAH was then added thereto and after stirring 1 hour, distilled water was added to precipitate the polymer. The precipitate was washed with distilled water and dried under reduced pressure. Furthermore, the polymer was dissolved in 100 ml of ethyl acetate and after adding hexane, the polymer precipitated was dried under reduced pressure to obtain the polymer as a powder. The weight average molecular weight of this powder determined by GPC was 10,000 in terms of standard polystyrene.

### [Synthesis Example 2: synthesis of Resin A-2 as resin (A)]

Acetoxystyrene, styrene and 1-phenylethyl methacrylate were charged at a ratio of 60/15/25 (by mol) and dissolved in tetrahydrofuran to prepare 100 mL of a solution having a solid content concentration of 20 mass%. Subsequently, 2 mol% of a polymerization initiator, V-65, produced by Wako Pure Chemical Industries, Ltd. was added thereto and the resulting solution was added dropwise to 10 ml of tetrahydrofuran heated at 60°C, over 4 hours in a nitrogen atmosphere. After the completion of dropwise addition, the reaction solution was heated for 4 hours, and 1 mol% of V-65 was again added, followed by stirring for 4 hours. After the completion of reaction, the reaction solution was cooled to room temperature and then crystallized from 3 L of hexane, and the precipitated white powder was collected by filtration.

The compositional ratio of the polymer determined from C¹³NMR was 58/16/26 (by mol). Also, the weight average molecular weight determined by GPC was 9,500 in terms of standard polystyrene.

This polymer was dissolved in 100 ml of tetrahydrofuran, 5 ml of TMAH was then added thereto and after stirring 1 hour, distilled water was added to precipitate the polymer. The precipitate was washed with distilled water and dried under reduced pressure. Furthermore, the polymer was dissolved in 100 ml of ethyl acetate and after adding hexane, the polymer precipitated was dried under reduced pressure to obtain the polymer as a powder. The weight average molecular weight of this powder determined by GPC was 10,000 in terms of standard polystyrene.

### [Synthesis Example 3: synthesis of Resin A-40 as resin (A)]:

Acetoxystyrene and 1-phenylethyl methacrylate were charged at a ratio of 90/10 (by mol) and dissolved in cyclohexanone to prepare 100 ml of a solution having a solid content concentration of 20 mass%. Subsequently, 2 mol% of a polymerization initiator, V-601, produced by Wako Pure Chemical Industries, Ltd. was added thereto, and the resulting solution was added dropwise to 10 ml of cyclohexanone heated at 80°C, over 4 hours in a nitrogen atmosphere. After the completion of dropwise addition, the reaction solution was heated for 4 hours, and 1 mol% of V-601 was again added, followed by stirring for 4 hours. After the completion of reaction, the reaction solution was cooled to room temperature and then crystallized from 3 L of hexane, and the precipitated white powder was collected by filtration.

The compositional ratio of the polymer determined from C¹³NMR was 89/11 (by mol). Also, the weight average molecular weight determined by GPC was 9,500 in terms of standard polystyrene.

This polymer was dissolved in 100 ml of tetrahydrofuran, 5 ml of TMAH was then added thereto and after stirring 1 hour, distilled water was added to precipitate the polymer. The precipitate was washed with distilled water and dried under reduced pressure. Furthermore, the polymer was dissolved in 100 ml of ethyl acetate and after adding hexane, the polymer precipitated was dried under reduced pressure to the polymer as a powder. The weight average molecular weight of this powder determined by GPC was 10,000 in terms of standard polystyrene.

The obtained resin was dissolved in PGMEA, pyridinium para-toluenesulfonic acid and ethyl vinyl ether were added thereto in an amount of 1 mol% and 25 mol%, respectively, based on the polymer, and the reaction was allowed to proceed at room temperature for 4 hours. After terminating the reaction by adding 10 mol% of triethylamine, the reaction product was washed with pure water, and PGMEA and water were removed by azeotropic distillation, whereby a PGMEA solution of Resin (A-40) was synthesized.

The compositional ratio of the polymer determined from C¹³NMR was 69/11120 (by mol). Also, the weight average molecular weight determined by GPC was 12,000 in terms of standard polystyrene.

Resins shown in Table 1, of which structures are illustrated above, were synthesized in the same manner as in Synthesis Examples 1, 2 and 3. In Table 1, the ratio of repeating units in each resin is a ratio of repeating units starting from the left in the structure illustrated above.

**Table 1**

| Resin | Repeating Unit (mol%) | Weight Average Molecular Weight | Dispersity |
|---|---|---|---|
| A-1 | 69/31 | 10000 | 1.69 |
| A-2 | 58/16/26 | 10000 | 1.68 |
| A-3 | 70/30 | 10000 | 1.65 |
| A-4 | 65/15/20 | 10500 | 1.65 |
| A-6 | 65/15/20 | 8000 | 1.59 |
| A-8 | 65/20/15 | 9000 | 1.65 |
| A-12 | 68/16/16 | 10000 | 1.69 |
| A-14 | 70/20/10 | 9500 | 1.68 |
| A-16 | 70/10/20 | 7500 | 1.60 |
| A-20 | 65/35 | 8900 | 1.52 |
| A-22 | 63/37 | 7500 | 1.59 |
| A-24 | 72/28 | 7600 | 1.50 |
| A-34 | 70/10/20 | 9500 | 1.68 |
| A-36 | 74/10/16 | 8200 | 1.60 |
| A-40 | 69/11/20 | 12000 | 1.69 |

The acid generators all were synthesized by a known synthesis method such as synthesis method described in JP-A-2002-27806.

### [Example 1]

### (1) Preparation and Coating of Resist

| | |
|---|---|
| Resin A-1 | 0.97 g |
| Acid Generator B-8 | 0.025 g |

These components were dissolved in 8.8 g of propylene glycol monomethyl ether acetate, and 0.003 g of D-1 (see below) as the organic basic compound and 0.001 g of Megafac F176 (produced by Dainippon Ink & Chemicals, Inc., hereinafter simply referred to as "W-1") as the surfactant were further added thereto and dissolved. The obtained solution was microfiltered through a membrane filter having a pore size of 0.1 µm to obtain a resist solution.

This resist solution was coated on a 8-inch silicon wafer by using a spin coater, ACT8, manufactured by Tokyo Electron Ltd. and then baked at 120°C for 60 seconds to obtain a uniform film having a thickness of 0.33 µm.

### (2) Production of Positive Resist Pattern

The resist film formed above was then subjected to KrF exposure using a KrF exposure apparatus (PAS5500/850C, manufactured by ASML). After the exposure, the resist film was baked at 130°C for 60 seconds, dipped in an aqueous 2.38 mass% tetramethylammonium hydroxide (TMAH) solution for 60 seconds, rinsed with water for 30 seconds and then dried. The obtained pattern was evaluated by the following methods.

### (2-1) LWR (Line Width Roughness)

With respect to a resist pattern obtained in the same manner as above, the line width was observed by a scanning electron microscope (eCD-2, manufactured by KLA) to inspect the line width fluctuation (LWR) at the line width of 170 nm. The line width was detected at a plurality of positions in the measuring monitor by using a length-measuring scanning electron microscope (SEM), and the amplitude dispersion (3σ) at the detection positions was used as an index for LWR.

### (2-2) Defocus Latitude Depended on Line Pitch

In a 0.17-µm line pattern at the irradiation dose giving the sensitivity above, the line width of a dense pattern (line:space = 1:1) and the line width of an isolated pattern were measured. The difference therebetween was taken as the defocus latitude depended on line pitch.

### (2-3) Profile

In a 0.17-µm line pattern, the cross-section of a dense pattern (line:space = 1:1) was observed using a scanning electron microscope (S4800, manufactured by Hitachi, Ltd.), and the cross-sectional profiles of the pattern were classified into three groups of rectangular, T-top and footing. Here, "T-top" indicates that the pattern has an eave-like top, "footing" indicates that the resist remains at the pattern bottom, and "rectangular" indicates that the profile is neither "T-top" nor "footing".

The results of Example 1 are shown in Table 2.

### [Examples 2 to 13 and Comparative Examples 1 to 3]

Using the compounds shown in Table 2, preparation, coating and KrF exposure evaluation of resist were performed thoroughly in the same manner as in Example 1. The evaluation results are shown in Table 2.

The component (c) and other component used in Examples and the resins used in Comparative Examples are as follows.

### [Organic Basic Compound]

- D-1:: Tri-n-hexylamine
- D-2:: 2,4,6-Triphenylimidazole
- D-3:: Tetra-(n-butyl)ammonium hydroxide

### [Other Components (Surfactant)]

- W-1:: Fluorine-containing surfactant, Megafac F176 (produced by Dainippon Ink & Chemicals, Inc.)
- W-2:: Fluorine/silicon-containing surfactant, Megafac R08 (produced by Dainippon Ink & Chemicals, Inc.)
- W-3:: Silicon-containing surfactant, Polysiloxane Polymer KP-341 (produced by Shin-Etsu Chemical Co., Ltd.)

**Table 2**

| | Resin | Acid Generator | Base (0.003 g) | Others (0.001 g) | LWR (nm) | Defocus Latitude Depended on Line Pitch (nm) | Profile |
|---|---|---|---|---|---|---|---|
| Example 1 | A-1 | B-8 (0.025 g) | D-1 | W-1 | 10.0 | 15 | rectangular |
| Example 2 | A-2 | B-8 (0.025 g) | D-1 | W-1 | 11.0 | 12 | rectangular |
| Example 3 | A-3 | B-8 (0.025 g) | D-1 | W-1 | 9.0 | 17 | rectangular |
| Example 4 | A-4 | B-8 (0.025 g) | D-1 | W-1 | 10.0 | 15 | rectangular |
| Example 5 | A-6 | B-8 (0.025 g) | D-1 | W-1 | 10.0 | 15 | rectangular |
| Example 6 | A-36 | B-8 (0.025 g) | D-1 | W-1 | 11 | 11 | rectangular |
| Example 7 | A-40 | B-8 (0.025 g) | D-1 | W-1 | 8.5 | 9 | rectangular |
| Example 8 | A-1 | B-18 (0.030 g) | D-1 | W-1 | 10.0 | 9 | rectangular |
| Example 9 | A-1 | B-19 (0.030 g) | D-1 | W-1 | 10.0 | 8.5 | rectangular |
| Example 10 | A-1 | B-10 (0.030 g) | D-1 | W-1 | 10.0 | 9.5 | rectangular |
| Example 11 | A-1 | B-14 (0.030 g) | D-1 | W-1 | 9.0 | 11 | rectangular |
| Example 12 | A-1 | B-8 (0.025 g) | D-2 | W-1 | 9.5 | 13 | rectangular |
| Example 13 | A-1 | B-8 (0.025 g) | D-3 | W-1 | 11.0 | 12 | rectangular |
| Example 14 | A-1 | B-8 (0.025 g) | D-1 | W-2 | 10.0 | 15 | rectangular |
| Example 15 | A-1 | B-8 (0.025 g) | D-1 | W-3 | 10.0 | 15 | rectangular |
| Example 16 | A-1 | B-18 (0.02 g) B-1 (0.01 g) | D-1 | W-1 | 9.5 | 9.5 | rectangular |
| Comparative Example 1 | E-1* (0.93 g) | C-12 (0.02 g) | D-1 | W-1 | 12 | 20 | tapered |
| Comparative Example 2 | E-1* (0.93 g) | B-8 (0.025 g) | D-1 | W-1 | 15 | 15 | footing |

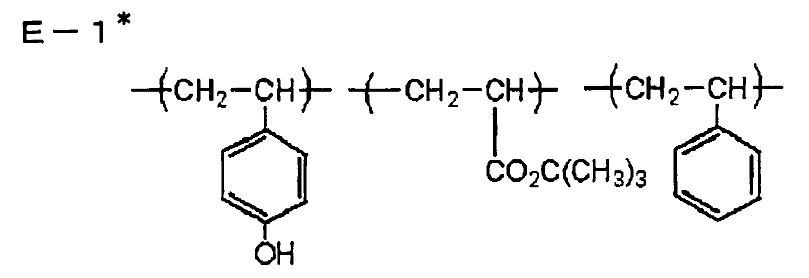

Molar compositional ratio: 65/20/15
Weight average molecular weight: 9,500
Dispersity: 1.88

It is seen from Table 2 that the resist composition of the present invention exhibits good defocus latitude depended on line pitch and good LWR performance and also ensures excellent pattern profile, as compared with the case using the compounds of Comparative Examples.

Furthermore, the resist composition of the present invention could form a good pattern even by the irradiation with electron beams or EUV.

According to the present invention, as regards the pattern formation by the irradiation of electron beam, KrF excimer laser light, EUV light or the like, a resist composition excellent in the sensitivity and resolving power and further excellent in the pattern profile, LWR performance and defocus latitude depended on line pitch, and a pattern forming method using the composition can be provided.

The entire disclosure of each and every foreign patent application from which the benefit of foreign priority has been claimed in the present application is incorporated herein by reference, as if fully set forth.

## Claims

1. A resist composition, which comprises:
(A) a resin containing a repeating unit represented by formula (I); and
(B) at least one compound represented by formula (II) or (II'): 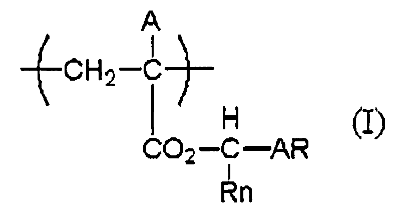 wherein AR represents a substituted or unsubstituted benzene ring or a substituted or unsubstituted naphthalene ring;
Rn represents a substituted or unsubstituted alkyl group, a substituted or unsubstituted cycloalkyl group or a substituted or unsubstituted aryl group; and
A represents a hydrogen atom, a substituted or unsubstituted alkyl group, a substituted or unsubstituted cycloalkyl group, a halogen atom, a cyano group or a substituted or unsubstituted alkyloxycarbonyl group: 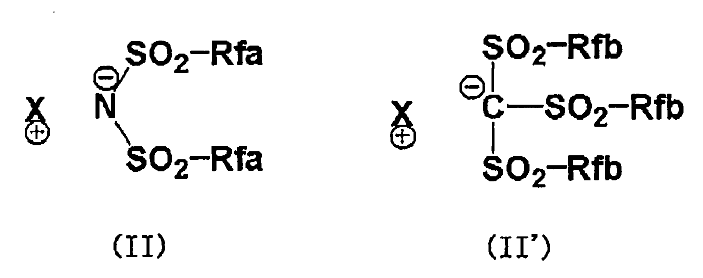 wherein Rfa and Rfb each independently represents a monovalent organic group having a fluorine atom, and two Rfa's or three Rfb's may be the same or different and may combine with each other to form a ring; and
X⁺ represents a sulfonium cation or an iodonium cation.

2. The resist composition according to claim 1,
wherein (A) the resin containing a repeating unit represented by formula (I) further contains a repeating unit represented by formula (A1): 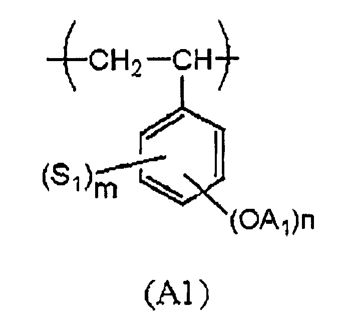 wherein n represents an integer of 0 to 3;
m represents an integer of 0 to 3, provided that m+n≤5;
A₁ represents a hydrogen atom or a group containing a group capable of decomposing under an action of an acid; and
S₁ represents a substituent, and when a plurality of S₁'s are present, the plurality of S₁'s may be the same or different.

3. The resist composition according to claim 2,
wherein in the repeating unit represented by formula (A1), the group containing a group capable of decomposing under an action of an acid represented by A₁ is an acetal group or a ketal group.

4. The resist composition according to claim 1,
wherein Rfa and Rfb each independently represents a fluorine-substituted alkyl group or a fluorine-substituted aryl group, and two Rfa's or three Rib's may be the same or different and may combine with each other to form a ring.

5. The resist composition according to claim 1,
wherein the sulfonium cation or the iodonium cation represented by X⁺ in formulae (II) and (II') has a structure represented by formula (B1) or (B2): 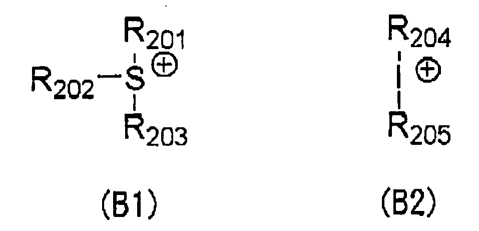 wherein in formula (B1), R₂₀₁, R₂₀₂ and R₂₀₃ each independently represents an organic group; and
in formula (B2), R₂₀₄ and R₂₀₅ each independently represents a substituted or unsubstituted aryl group, a substituted or unsubstituted alkyl group or a substituted or unsubstituted cycloalkyl group.

6. The resist composition according to claim 5,
wherein X⁺ represents the sulfonium cation having the structure represented by formula (B1), and
the structure represented by formula (B1) is an arylsulfonium structure (B1a) in which at least one of R₂₀₁ to R₂₀₃ in formula (B1) is a substituted or unsubstituted aryl group,

7. The resist composition according to claim 5,
wherein X⁺ represents the sulfonium cation having the structure represented by formula (B1), and
the structure represented by formula (B1) is a structure (B1b) in which R₂₀₁ to R₂₀₃ in formula (B1) each independently represents an organic group not containing an aromatic ring.

8. The resist composition according to claim 5,
wherein X⁺ represents the sulfonium cation having the structure represented by formula (B1), and
the structure represented by formula (B1) is an arylacylsulfonium salt structure represented by formula (B1c): 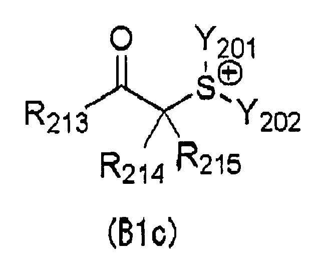 wherein R₂₁₃ represents a substituted or unsubstituted aryl group;
R₂₁₄ and R₂₁₅ each independently represents a hydrogen atom, a substituted or unsubstituted alkyl group or a substituted or unsubstituted cycloalkyl group;
Y₂₀₁ and Y₂₀₂ each independently represents a substituted or unsubstituted alkyl group, a substituted or unsubstituted cycloalkyl group, a substituted or unsubstituted aryl group or a substituted or unsubstituted vinyl group, provided that R₂₁₃ and R₂₁₄ may combine with each other to form a ring structure, R₂₁₄ and R₂₁₅ may combine with each other to form a ring structure, and Y₂₀₁ and Y₂₀₂ may combine with each other to form a ring structure, and the ring structure formed may contain an oxygen atom, a sulfur atom, an ester bond or an amide bond.

9. A pattern forming method, which comprises:
forming a resist film from the resist composition according to claim 1; and
exposing and developing the resist film.
